# EUROPEAN PATENT APPLICATION

(11) **EP 4 593 545 A1**
(43) Date of publication of application: **30.07.2025**
(21) Application number: 25150851.1
(22) Date of filing: 09.01.2025
(51) Int. Cl.: H10B 12/00

(54) **SEMICONDUCTOR DEVICES INCLUDING CAPACITORS**

(30) Priority: 26.01.2024 KR 20240012460
(71) Applicant: Samsung Electronics Co., Ltd., Suwon-si, Gyeonggi-do 16677 (KR)
(72) Inventor: CHO, Byunghoon, 16677 Suwon-si (KR); KANG, Namjung, 16677 Suwon-si (KR); NAM, Kiheum, 16677 Suwon-si (KR); JEONG, Jeonwon, 16677 Suwon-si (KR); CHOI, Jihyun, 16677 Suwon-si (KR)
(74) Representative: Marks & Clerk LLP

(57) **Abstract**

According to an example embodiment of the present disclosure, a semiconductor device includes a substrate including a first region and a second region; a capacitor on the substrate in the first region, wherein the capacitor includes a lower electrodes, supporter layers connected to between the lower electrodes, a dielectric layer covering the supporter layers and the lower electrodes, and an upper electrode on the dielectric layer; a first upper conductive pattern in contact with an upper surface of the upper electrode; a second upper conductive pattern on the first upper conductive pattern; an upper contact plug between the first upper conductive pattern and the second upper conductive pattern; an interlayer insulating layer disposed on the second region of the substrate of the second region and disposed on an outer surface of the upper electrode; and a first peripheral conductive line disposed on the interlayer insulating layer and disposed on the same vertical level as a vertical level of at least a portion of the first upper conductive pattern.

## Description

### BACKGROUND

Example embodiments relate to a semiconductor device including a capacitor.

Recently, electronic devices include semiconductor devices with reduced size and which process high-capacity data. Particularly, in the case of a memory semiconductor device, as a size of a memory cell has been reduced for high integration density, and an interconnection structure for applying an electrical signal for operation of memory cells included in a semiconductor device has become complex. Accordingly, there is a desire for semiconductor devices having improved integration density and sufficient reliability, which may be easily manufactured.

### SUMMARY

Example embodiments include a semiconductor device having increased integration density and improved reliability.

According to an example embodiment of the present disclosure, a semiconductor device includes a substrate including a first region and a second region; a capacitor on the substrate in the first region, wherein the capacitor includes a lower electrode, supporter layers connected to the lower electrodes, a dielectric layer covering the supporter layers and the lower electrode, and an upper electrode on the dielectric layer; a first upper conductive pattern in contact with an upper surface of the upper electrode; a second upper conductive pattern on the first upper conductive pattern; an upper contact plug between the first upper conductive pattern and the second upper conductive pattern; an interlayer insulating layer disposed on the second region of the substrate and disposed on an outer surface of the upper electrode; and a first peripheral conductive line disposed on the interlayer insulating layer and disposed on the same vertical level as a vertical level of at least a portion of the first upper conductive pattern.

According to an example embodiment of the present disclosure, a semiconductor device includes a substrate including a cell region including a bit line and a memory structure disposed at a vertical level higher than a vertical level of the bit line, and a peripheral region including peripheral circuits; a first upper conductive pattern disposed on the memory structure on the cell region; a second upper conductive pattern on the first upper conductive pattern; a first peripheral conductive line extending in a first direction on the peripheral region and disposed at the same vertical level as a vertical level of at least a portion of the first upper conductive pattern; a first peripheral pattern and a second peripheral pattern disposed on the first peripheral conductive line on the same vertical level as a vertical level of at least a portion of the second upper conductive pattern and spaced apart from each other in the first direction; a first intermediate contact plug disposed between the first peripheral conductive line and the first peripheral pattern; and a second intermediate contact plug disposed between the first peripheral conductive line and the second peripheral pattern.

According to an example embodiment of the present disclosure, a semiconductor device includes a substrate including a cell region and a peripheral region surrounding the cell region; a bit line disposed on the cell region; a capacitor disposed on the cell region and disposed at a vertical level higher than a vertical level of the bit line, wherein the capacitor includes lower electrode structures, supporter layers between the lower electrode structures, a dielectric layer covering the lower electrode structures, and an upper electrode on the dielectric layer; a first upper conductive pattern in contact with and vertically above an upper surface of the upper electrode; a second upper conductive pattern on the first upper conductive pattern; an upper contact plug electrically connecting the first upper conductive pattern to the second upper conductive pattern; a first interlayer insulating layer disposed on the substrate of the peripheral region and disposed on an external side surface of the upper electrode; a first peripheral conductive line disposed at the interlayer insulating layer and disposed at the same vertical level as a vertical level of at least a portion of the first upper conductive pattern; a first peripheral pattern and a second peripheral pattern disposed on the same level as a level of at least a portion of the second upper conductive pattern on the first peripheral conductive line, and spaced apart from each other; and intermediate contact plugs respectively disposed between each of the first and second peripheral patterns and the first peripheral conductive line.

At least some of the above and other features of the invention are set out in the claims.

### BRIEF DESCRIPTION OF DRAWINGS

These and other aspects, features, and advantages of the example embodiments will be more clearly understood from the following detailed description, taken in combination with the accompanying drawings, in which:
FIG. 1A is a plan diagram illustrating a cell region of a semiconductor device according to an example embodiment of the present disclosure;
FIG. 1B is a plan diagram illustrating peripheral regions of a semiconductor device according to an example embodiment of the present disclosure;
FIG. 2A is cross-sectional diagrams illustrating a cell region taken along lines I-I' and V-V' in FIG. 1A according to an example embodiment of the present disclosure;
FIG. 2B is cross-sectional diagrams illustrating a second peripheral region taken along lines II-II' and III-III' in FIG. 1B according to an example embodiment of the present disclosure;
FIG. 2C is a cross-sectional diagram illustrating a first peripheral region taken along line IV-IV' in FIG. 1B according to an example embodiment of the present disclosure;
FIG. 3A is a plan diagram illustrating a second peripheral region of a semiconductor device according to another example embodiment of the present disclosure;
FIG. 3B is cross-sectional diagrams illustrating a second peripheral region taken along lines A-A' and B-B' in FIG. 3A according to an example embodiment of the present disclosure;
FIGS. 4A to 4C are cross-sectional diagrams illustrating a semiconductor device according to another example embodiment of the present disclosure;
FIGS. 5A and 5B are cross-sectional diagrams illustrating a semiconductor device according to another example embodiment of the present disclosure;
FIGS. 6A and 6B are cross-sectional diagrams illustrating first and second peripheral regions according to an example embodiment of the present disclosure;
FIG. 7 is a cross-sectional diagram illustrating a first peripheral region of a semiconductor device according to an example embodiment of the present disclosure;
FIG. 8A is a plan diagram illustrating a cell connection structure disposed in a cell region of a semiconductor device and a peripheral connection structure disposed in peripheral regions according to an example embodiment of the present disclosure;
FIG. 8B is a perspective diagram illustrating peripheral connection structures illustrated in FIG. 8A according to an example embodiment of the present disclosure;
FIG. 9A is a plan diagram illustrating a cell connection structure disposed in a cell region of a semiconductor device and a peripheral connection structure disposed in peripheral regions according to an example embodiment of the present disclosure;
FIG. 9B is a perspective diagram illustrating peripheral connection structures in FIG. 9A according to an example embodiment of the present disclosure;
FIG. 10A is a plan diagram illustrating a cell connection structure disposed in a cell region of a semiconductor device and a peripheral connection structure disposed in peripheral regions according to an example embodiment of the present disclosure;
FIG. 10B is a perspective diagram illustrating peripheral connection structures in FIG. 10A according to an example embodiment of the present disclosure;
FIG. 11 is a plan diagram illustrating a cell connection structure disposed in a cell region of a semiconductor device and a peripheral connection structure disposed in peripheral regions according to an example embodiment of the present disclosure; and
FIGS. 12A to 12D are diagrams illustrating a method of manufacturing a semiconductor device according to an example embodiment of the present disclosure.

### DETAILED DESCRIPTION

Hereinafter, embodiments will be described as follows with reference to the accompanying drawings.

Throughout the specification, when a component is described as "including" a particular element or group of elements, it is to be understood that the component is formed of only the element or the group of elements, or the element or group of elements may be combined with additional elements to form the component, unless the context indicates otherwise. The term "consisting of," on the other hand, indicates that a component is formed only of the element(s) listed.

Ordinal numbers such as "first," "second," "third," etc. may be used simply as labels of certain elements, steps, etc., to distinguish such elements, steps, etc. from one another. Terms that are not described using "first," "second," etc., in the specification, may still be referred to as "first" or "second" in a claim. In addition, a term that is referenced with a particular ordinal number (e.g., "first" in a particular claim) may be described elsewhere with a different ordinal number (e.g., "second" in the specification or another claim).

Spatially relative terms, such as "beneath," "below," "lower," "above," "upper," "top," "bottom," and the like, may be used herein for ease of description to describe one element's or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the term "below" can encompass both an orientation of above and below. The device may be otherwise oriented (rotated 90 degrees or at other orientations) and the spatially relative descriptors used herein interpreted accordingly. A "level" as described herein may be a vertical level (e.g., a height along a vertical direction that is a particular distance from a horizontal plane such as a top surface of a substrate).

It will be understood that when an element is referred to as being "connected" or "coupled" to or "on" another element, it can be directly connected or coupled to or on the other element or intervening elements may be present. In contrast, when an element is referred to as being "directly connected" or "directly coupled" to another element, or as "contacting" or "in contact with" another element (or using any form of the word "contact"), there are no intervening elements present at the point of contact.

Terms such as "same," "equal," "planar," or "coplanar," as used herein when referring to orientation, layout, location, shapes, sizes, compositions, amounts, or other measures do not necessarily mean an exactly identical orientation, layout, location, shape, size, composition, amount, or other measure, but are intended to encompass nearly identical orientation, layout, location, shapes, sizes, compositions, amounts, or other measures within typical variations that may occur resulting from conventional manufacturing processes. The term "substantially" may be used herein to emphasize this meaning, unless the context or other statements indicate otherwise. For example, items described as "substantially the same," "substantially equal," or "substantially planar," may be exactly the same, equal, or planar, or may be the same, equal, or planar within acceptable variations that may occur, for example, due to manufacturing processes.

Components described herein as "integrated" or "integrated with each other" are formed to include a continuously-formed material, so as to form a monolithic structure.

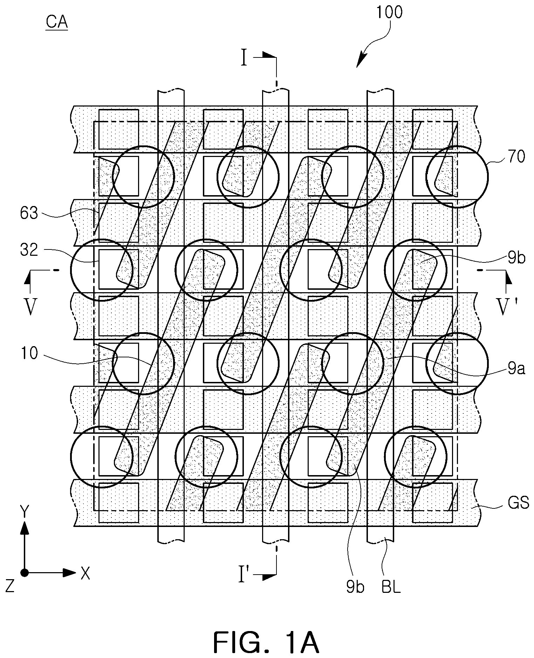

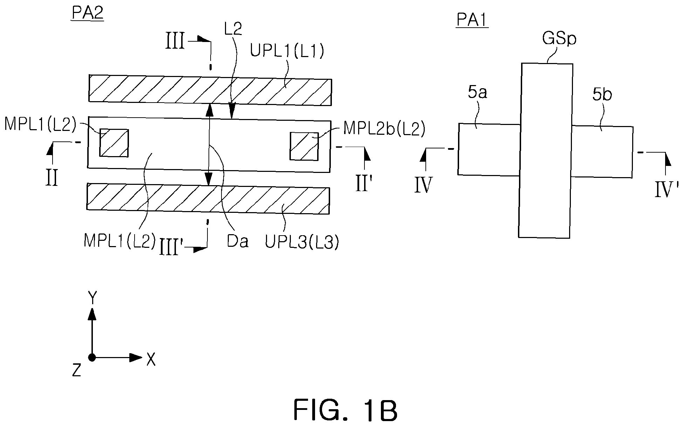

FIG. 1A is a plan diagram illustrating a cell region of a semiconductor device according to an example embodiment. FIG. 1B is a plan diagram illustrating peripheral regions of a semiconductor device according to an example embodiment.

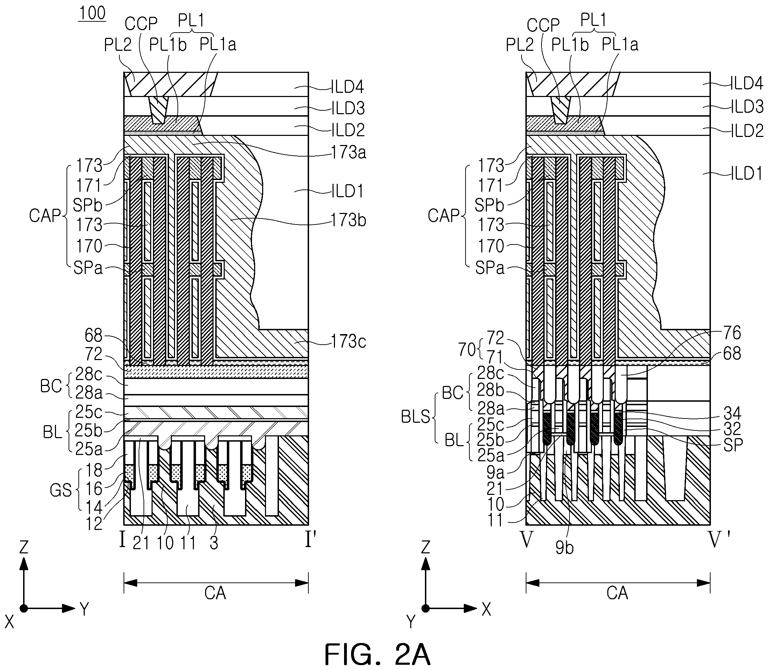

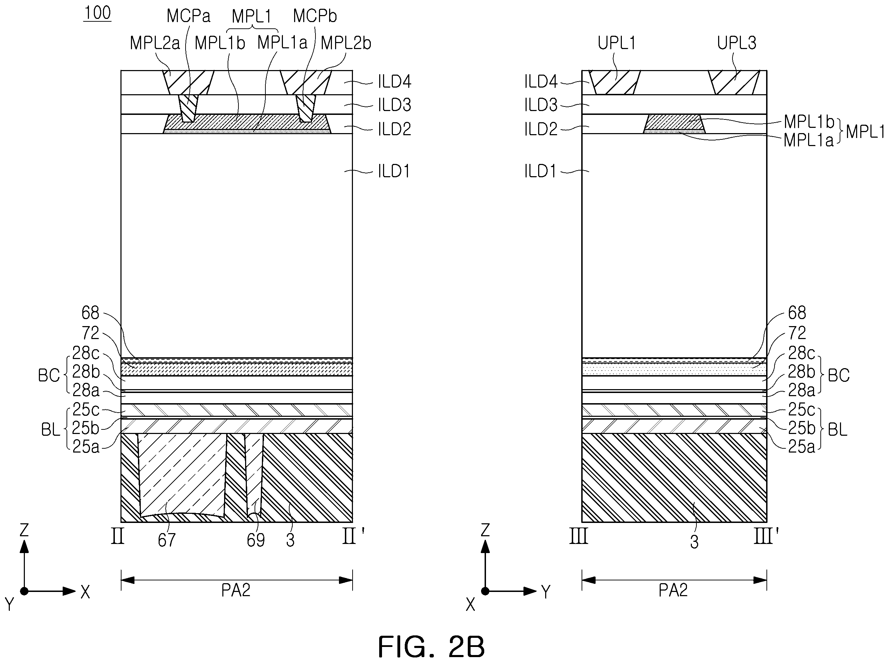

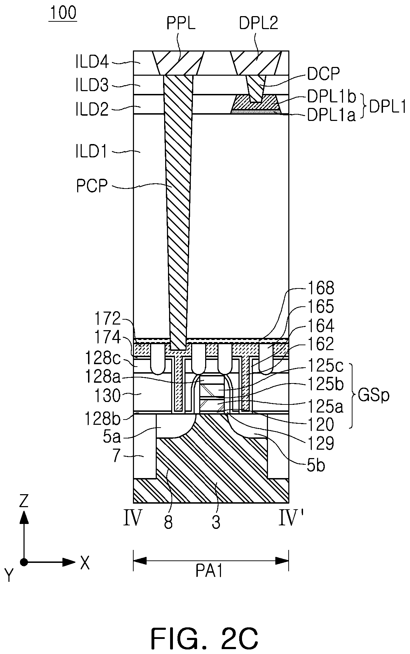

FIG. 2A is cross-sectional diagrams illustrating a cell region taken along lines I-I' and V-V' in FIG. 1A according to an example embodiment. FIG. 2B is cross-sectional diagrams illustrating a second peripheral region taken along lines II-II' and III-III' in FIG. 1B according to an example embodiment. FIG. 2C is a cross-sectional diagram illustrating a first peripheral region taken along line IV-IV' in FIG. 1B according to an example embodiment.

Referring to FIGS. 1A and 1B, the semiconductor device 100 may include a cell region CA and peripheral regions PA1 and PA2 adjacent to the cell region CA.

The cell region CA may be a region in which a memory cell of a dynamic random access memory (DRAM) device is disposed, and the peripheral regions PA1 and PA2 may be regions in which a wordline driver, a sense amplifier, row and column decoders and control circuits are disposed.

The peripheral regions PA1 and PA2 may be disposed adjacent to the cell region CA. The peripheral regions PA1 and PA2 may surround the cell region CA, for example, to be arranged around the cell region CA from a plan view. The peripheral regions PA1 and PA2 may include the first peripheral region PA1 and the second peripheral region PA2 extending from the first peripheral region PA1. In some embodiments, the second peripheral region PA2 may be disposed between the cell region CA and the first peripheral region PA1. In some embodiments, the cell region CA, the second peripheral region PA2 and the first peripheral region PA1 may be disposed to be adjacent to each other sequentially. As can be seen from FIGS. 2B-2C, only a portion of the peripheral regions is shown. In example embodiments, the peripheral regions PA1 and PA2 may be between the cell region CA and an edge of the substrate 3 and may be adjacent to the edge of the substrate 3.

Referring to FIGS. 1A and 2A, the semiconductor device 100 may include the substrate 3 including a first active region 10 in the cell region CA, a bit line structure BLS including the bit line BL on the substrate 3, a cell gate structure GS on the substrate 3, a capacitor CAP on the bit line structure BLS, a first upper conductive pattern PL1 on the capacitor CAP, and a second upper conductive pattern PL2 on the first upper conductive pattern PL1. The capacitor CAP may store data, and may be a capacitor structure of DRAM, for example. The capacitor CAP may be referred to as a data storage structure.

For example, the semiconductor device 100 may include a cell array of a dynamic random access memory (DRAM). For example, the bit line BL may be connected to a first impurity region 9a of the first active region 10, and a second impurity region 9b of the first active region 10 may be electrically connected to the capacitor CAP on a landing pad 70 through the contact plug 32 and the landing pad 70.

The capacitor CAP may be electrically connected to the contact plug 32 and the landing pad 70 on the lower structure including the contact plug 32 and the landing pad 70. A lower structure may include the substrate 3, the cell gate structure GS, and the bit line structure BLS.

The capacitor CAP may include a lower electrode 170, a dielectric layer 171 on the lower electrode 170, and an upper electrode 173 on the dielectric layer 171. The capacitor CAP may further include first and second supporter layers SPa and SPb. A plurality of capacitors may be formed by a plurality of lower electrodes 170.

The semiconductor device 100 may include the substrate 3, the cell gate structure GS, the buffer layer 21, the bit line structure BLS, the contact plug 32, the landing pad 70, the insulating patterns 76 and the capacitor CAP (or a data storage structure) in the cell region CA. As can be seen from the figures, various items described in the singular herein (e.g., with a single reference number and discussion of a single instance of the item) may be provided in plural.

The substrate 3 may include a semiconductor material, such as a group IV semiconductor, a group III-V compound semiconductor, or a group II-VI compound semiconductor. For example, a group IV semiconductor may be silicon, germanium, or silicon-germanium. The substrate 3 may be configured as a silicon substrate, silicon on insulator (SOI) substrate, germanium substrate, germanium on insulator (GOI) substrate, silicon-germanium substrate, or a substrate including an epitaxial layer.

In the cell region CA, the substrate 3 may include a first active region 10, a first device isolation layer 11, a first impurity region 9a and a second impurity region 9b. The first device isolation layer 11 may be configured as an insulating layer extending downwardly from an upper surface of the substrate 3, and may define the first active region 10. For example, the first active region 10 may correspond to a portion of an upper surface of the substrate 3 surrounded by the first device isolation layer 11.

The first active region 10 may connect to first and second impurity regions 9a and 9b extending from an upper surface of the substrate 3 to a predetermined depth. The first and second impurity regions 9a and 9b may be spaced apart from each other. The first and second impurity regions 9a and 9b may be provided as source/drain regions of the transistor. For example, with respect to a single first active region 10, two cell gate structures GS may cross the first active region 10, and a drain region may be formed between the two cell gate structures GS, and source regions may be formed in regions opposite to a drain region for two cell gate structures GS. For example, the first impurity region 9a may correspond to the drain region, and the second impurity region 9b may correspond to the source region. The source region and the drain region may be formed by the first and second impurity regions 9a and 9b by doping or ion implantation of substantially the same impurities, and may be referred to interchangeably depending on a circuit configuration of the finally formed transistor. The first and second impurity regions 9a and 9b may include impurities having a conductivity type opposite to that of the substrate 3. For example, the first active region 10 may include p-type impurities, and the first and second impurity regions 9a and 9b may have N-type impurities.

The first device isolation layer 11 may extend downwardly from an upper surface of the substrate 3 and may define the first active regions 10. The first device isolation layer 11 may surround the first active region 10 and may allow the region to be separated. The first device isolation layer 11 may include silicon oxide, silicon nitride, silicon oxynitride, or a combination thereof, and may be a single layer or a plurality of layers.

In the cell region CA, the cell gate structures GS may extend in the first direction (X-direction) and may be spaced apart from each other in the second direction (Y-direction). Also, the cell gate structures GS may cross the first active region 10. For example, in the first active region 10, two cell gate structures GS may intersect with the first active region 10. Transistors including the cell gate structure GS and the first and second impurity regions 9a and 9b, respectively, may form a buried channel array transistor (BCAT), but an example embodiment thereof is not limited thereto.

In the cross-sectional diagram, the cell gate structures GS may be buried in the substrate 3. For example, the cell gate structures GS may be disposed in the gate trench 12 formed in the substrate 3. The cell gate structure GS may include a gate dielectric layer 14, a gate electrode 16, and a gate capping layer 18 disposed in the gate trench 12. The gate dielectric layer 14 may be formed conformally on an internal wall of the gate trench 12. The gate electrode 16 may be disposed within the gate trench 12, and the gate capping layer 18 may be disposed on the gate electrode 16 and may fill the gate trench 12.

The gate dielectric layer 14 may include silicon oxide or a high-κ material. In illustrative example embodiments, the gate dielectric layer 14 may be formed by oxidizing the first active region 10, or may be formed by deposition. The gate electrode 16 may include, for example, at least one of polycrystalline silicon (Si), titanium (Ti), titanium nitride (TiN), tantalum (Ta), tantalum nitride (TaN), tungsten (W), tungsten nitride (WN), and aluminum (Al). The gate capping layer 18 may include silicon nitride.

In the cell region CA, the buffer layer 21 may be disposed on the first active region 10, the first device isolation layer 11 and the cell gate structure GS. The buffer layer 21 may include silicon oxide, silicon nitride, silicon oxynitride, or a combination thereof. The buffer layer 21 may be configured as a single layer or multiple layers.

In the cell region CA, the bit line structure BLS may extend in the second direction (Y-direction) and may be spaced apart from each other in the first direction (X-direction). The bit line structure BLS may have a bar shape extending in the second direction (Y-direction). The bit line structure BLS may include a bit line BL and a bit line capping layer BC on the bit line BL. The bit line BL may include a first conductive layer 25a, a second conductive layer 25b, and a third conductive layer 25c, stacked in order on the buffer layer 21. In one embodiment, the first conductive layer 25a may be polysilicon, and the second conductive layer 25b may be a metal-semiconductor compound. For example, the metal-semiconductor compound may be configured as a layer in which a portion of the first conductive layer 25a is silicided. For example, the metal-semiconductor compound may be cobalt silicide (CoSi), titanium silicide (TiSi), nickel silicide (NiSi), tungsten silicide (WSi), or other metal silicides, or may include nitrides such as TiSiN. The third conductive layer 25c may be a metal material such as titanium (Ti), tantalum (Ta), tungsten (W), and aluminum (Al). The bit line BL may further include a plug portion disposed below the first conductive layer 25a, extending downwardly and in contact with the second impurity region 9b.

The bit line capping layer BC may include a first capping layer 28a, a second capping layer 28b, and a third capping layer 28c disposed on the bit line BL. A side surface of first capping layer 28a may be coplanar with side surfaces of the first conductive layer 25a, the second conductive layer 25b and the third conductive layer 25c. The first capping layer 28a, the second capping layer 28b and the third capping layer 28c may include silicon oxide, silicon nitride, silicon oxynitride, or a combination thereof, for example, silicon nitride.

The spacer structures SP may be disposed on both (e.g., opposite) side surfaces of the bit line structures BLS, respectively, and may extend in the second direction (Y-direction) along side surfaces of the bit line structures BLS. The spacer structure SP may include silicon oxide, silicon nitride, silicon oxynitride, or a combination thereof. The spacer structure SP in example embodiments is merely an example, and a material of the spacer structure SP and the number of layers thereof are not limited thereto and may be varied.

A lower end of the contact plug 32 may be disposed at a level lower than a level of an upper surface of the substrate 3, and an upper surface of the contact plug 32 may be disposed at a level lower than a level of an upper end of the bit line structure BLS. The contact plug 32 may extend into the substrate 3, may penetrate the buffer layer 21, may be in contact with the second impurity region 9b of the first active region 10, and may be electrically connected to the second impurity region 9b. The contact plug 32 may be formed of a conductive material, and may include, for example, at least one of polysilicon (Poly-Si), titanium (Ti), titanium nitride (TiN), tantalum (Ta), tantalum nitride (TaN), tungsten (W), tungsten nitride (WN), and aluminum (Al). In an example embodiment, the contact plug 32 includes doped polysilicon and include N-type impurities such as one or more of phosphorus (P), arsenic (As) and antimony (Sb).

Referring to FIG. 1A, the semiconductor device 100 may further include a fence structure 63 disposed between the bit line structures BLS. In the plan diagram, the fence structures 63 may overlap the cell gate structures GS in the vertical direction and may be disposed alternately with the contact plug 32 in the second direction (Y-direction). The fence structures 63 may spatially isolate the contact plugs 32 from each other and may electrically insulate the contact plugs 32 from each other. The fence structure 63 may have a bar shape or a pillar shape extending in the vertical direction. Although not illustrated, a lower surface of the fence structure 63 may be in contact with the gate capping layer 18 of the cell gate structure GS. The fence structure 63 may include an insulating material, for example, silicon nitride.

A metal-semiconductor compound layer 34 may be disposed between the contact plug 32 and the landing pad 70. For example, when the contact plug 32 includes a semiconductor material, the metal-semiconductor compound layer 34 may be obtained by siliciding a portion of the contact plug 32. The metal-semiconductor compound layer 34 may include, for example, cobalt silicide (CoSi), titanium silicide (TiSi), nickel silicide (NiSi), tungsten silicide (WSi), or other metal silicide. In another example, the metal-semiconductor compound layer 34 may not be provided.

The landing pad 70 may be disposed on the contact plug 32. The contact plug 32 may extend to a region between the spacer structures SP and may cover an upper surface of the metal-semiconductor compound layer 34. The landing pad 70 may include a barrier layer 71 and a conductive layer 72. The barrier layer 71 may cover a lower surface and side surfaces of the conductive layer 72. The barrier layer 71 may include at least one metal nitride, such as titanium nitride (TiN), tantalum nitride (TaN), and tungsten nitride (WN). The conductive layer 72 may include a conductive material, such as at least one of polycrystalline silicon (Si), titanium (Ti), tantalum (Ta), tungsten (W), ruthenium (Ru), copper (Cu), molybdenum (Mo), platinum (Pt), nickel (Ni), cobalt (Co), aluminum (Al), titanium nitride (TiN), tantalum nitride (TaN), and tungsten nitride (WN).

The insulating patterns 76 may be disposed to penetrate the landing pad 70. The landing pad 70 may be divided into multiple portions by the insulating patterns 76. The insulating patterns 76 may include at least one of an insulating material, for example, silicon oxide, silicon nitride, and silicon oxynitride.

The etch stop layer 68 may cover the insulating patterns 76 between the lower electrodes 170. The etch stop layer 68 may extend to the peripheral regions PA1 and PA2. The etch stop layer 68 may be in contact with a lower region of side surfaces of the lower electrodes 170. The etch stop layer 68 may be disposed below the support layers SPa and SPb. An upper surface of the etch stop layer 68 may include a portion in direct contact with the dielectric layer 171. For example, the etch stop layer 68 may include at least one of silicon nitride and silicon oxynitride.

The lower electrodes 170 may be disposed on the conductive layer 72. The lower electrodes 170 may penetrate the etch stop layer 68 and may be in contact with the conductive layer 72. The lower electrodes 170 and the conductive layer 72 may have a pillar shape, but example embodiments thereof is not limited thereto. Each of the lower electrodes 170 and the conductive layer 72 may include at least one of niobium nitride (NbN), niobium oxide (NbOx), polycrystalline silicon (Si), iridium (Ir), titanium (Ti), titanium nitride (TiN), titanium silicide nitride (TiSiN), tantalum (Ta), tantalum nitride (TaN) ), tungsten (W), tungsten nitride (WN), and aluminum (Al), or combinations thereof, metal nitride, metal compound, or the like.

The dielectric layer 171 may cover a side surface and an upper surface of each of the lower electrodes 170 on a surface of the lower electrodes 170. The dielectric layer 171 may be disposed between the lower electrodes 170 and the upper electrode 173. The dielectric layer 171 may cover upper and lower surfaces of the support layers SPa and SPb. The dielectric layer 171 may cover an upper surface of the etch stop layer 68.

The dielectric layer 171 may include a high-κ material, silicon oxide, silicon nitride, or a combination thereof. However, in example embodiments, the dielectric layer 171 may be at least one of titanium (Ti), tantalum (Ta), hafnium (Hf), aluminum (Al), zirconium (Zr), and lanthanum (La) doped with fluorine (F) or oxide, nitride, silicide, oxynitride, or silico-oxynitride including combinations thereof.

The upper electrode 173 may be disposed on the dielectric layer 171. The upper electrode 173 may fill a space between the lower electrodes 170 and a space between the supporter layers SPa and SPb. The upper electrode 173 may include a conductive material. In an example, the upper electrode 173 may include at least one of silicon-germanium (SiGe) or silicon (Si).

The upper electrode 173 may include a first portion 173a, a second portion 173b, and a third portion 173c. In an example embodiment, the first portion 173a may fill a space between the lower electrodes 170 and the supporter layers SPa and SPb on the substrate 3 and may be disposed on the dielectric layer 171. For example, a portion of the upper electrode 173 directly above a topmost surface of the dielectric layer 171 as well as a portion of the upper electrode 173 formed between lower electrodes 170 may be the first portion 173a. In an example embodiment, the second portion 173b may extend from the first portion 173a and may surround the other components of the capacitor CAP in a horizontal direction. The second portion 173b may surround the first portion 173a and may extend from a level above a top of the lower electrodes 170 to a level below a level where the supporter layer SPa is formed. The second portion 173b may include a curved side surface. The second portion 173b may further include at least one protrusion. The at least one protrusion (not illustrated) may overlap the support layers SPa and SPb in the horizontal direction. In an example embodiment, the third portion 173c may be a portion extending from the second portion 173b and protruding toward the peripheral regions PA1 and PA2. The third portion 173c may extend in the horizontal direction on and along the etch stop layer 68. The third portion 173c may not overlap the support layers SPa and SPb in the horizontal direction.

The supporter layers SPa and SPb may include a first supporter layer SPa and a second supporter layer SPb above the first supporter layer SPa. The support layers SPa and SPb may be spaced apart from the substrate 3 in a direction perpendicular to an upper surface of the substrate 3. The support layers SPa and SPb may be in contact with the lower electrodes 170 and may extend in a direction parallel to an upper surface of the substrate 3.

The supporter layers SPa and SPb may be configured to support the lower electrodes 170 having a high aspect ratio. The support layers SPa and SPb may include, for example, at least one of silicon nitride, silicon oxynitride, or a material similar thereto. The number of the supporter layers SPa and SPb, the thickness thereof and/or dispositional relationship therebetween are not limited to the illustrated examples and may vary in example embodiments.

The first insulating layer ILD1 (or, interlayer insulating layer) may fill a step difference formed due to the capacitor CAP disposed in the cell region CA. The first insulating layer ILD1 may surround the capacitor CAP in the horizontal first direction (X-direction) and may extend to the peripheral regions PA1 and PA2. An upper surface of the first insulating layer ILD1 may be disposed at the same level as a level of an upper surface of the upper electrode 173. In the example, an upper surface of the first insulating layer ILD1 may be disposed at the same level as a level of au upper of the first portion 173a of the upper electrode 173. The first insulating layer ILD1 may be in contact with the second portion 173b and the third portion 173c of the upper electrode 173.

The first upper conductive pattern PL1 may be disposed on the upper electrode 173 in the cell region CA and may be electrically connected to the upper electrode 173. In an example embodiment, the first upper conductive pattern PL1 may be disposed on the first portion 173a of the upper electrode 173. The first upper conductive pattern PL1 may contact an upper surface of the first portion 173a of the upper electrode 173. In an example embodiment, the first upper conductive pattern PL1 may not overlap the second portion 173b and the third portion 173c of the upper electrode 173 in the vertical direction (Z-direction). For example, the first upper conductive pattern PL1 may be formed within a footprint of the upper electrodes 173 from a plan view, and the second portion 173b and third portion 173c may be formed outside of the footprint.

The first upper conductive pattern PL1 may include a first barrier layer PL1a and a first electrode layer PL1b. The first barrier layer PL1a may be disposed on a lower surface of the first electrode layer PL1b. In the example, a width of the first upper conductive pattern PL1a in the horizontal direction may decrease upwardly. The first barrier layer PL1a may include metal nitride such as titanium nitride (TiN). In an example, the first electrode layer PL1b may include at least one of silicon-germanium (SiGe), tungsten (W), tungsten nitride (WN), or titanium nitride (TiN).

The second insulating layer ILD2 may be disposed on the first insulating layer ILD1. The second insulating layer ILD2 may surround a side surface of the first upper conductive pattern PL1. In an example embodiment, an upper surface of the second insulating layer ILD2 may be disposed at substantially the same level as a level of an upper surface of the first upper conductive pattern PL1.

The second upper conductive pattern PL2 may be disposed on the first upper conductive pattern PL1. The second upper conductive pattern PL2 may overlap the first upper conductive pattern PL1 in the vertical direction (Z-direction). A width of the second upper conductive pattern PL2 in the horizontal direction may decrease downwardly. In example embodiments, the second upper conductive pattern PL2 may extend in the first direction (X direction).

The third insulating layer ILD3 may be disposed on the second insulating layer ILD2. The second upper conductive pattern PL2 may be disposed on the third insulating layer ILD3. An upper surface of the third insulating layer ILD3 may be disposed at substantially the same level as a level of a lower surface of the second upper conductive pattern PL2.

The second upper conductive pattern PL2 may be electrically connected to the first upper conductive pattern PL1 through the upper contact plug CCP. The upper contact plug CCP may penetrate the third insulating layer ILD3 and may electrically connect the first upper conductive pattern PL1 to the second upper conductive pattern PL2. A lower surface of the upper contact plug CCP may be disposed at a level lower than a level of an upper surface of the first upper conductive pattern PL1.

The second upper conductive pattern PL2 may include a conductive material. In one example, the second upper conductive pattern PL2 may include copper (Cu).

The fourth insulating layer ILD4 may be disposed on the third insulating layer ILD3. The fourth insulating layer ILD4 may cover a side surface of the second upper conductive pattern PL2.

The first to fourth insulating layers ILD1-ILD4 may extend to the peripheral regions PA1 and PA2. Each of the first to fourth insulating layers II,D1-II,D4 may include at least one of silicon oxide or silicon nitride.

Referring to FIGS. 1B and 2B, the second peripheral region PA2 of the semiconductor device 100 may include a plurality of interconnection structures L1, L2, and L3. The plurality of interconnection structures L1, L2, and L3 may provide an electrical path between peripheral circuits or an electrical path for connecting the cell region CA to the peripheral circuit. The plurality of interconnection structures L1, L2, and L3 may be disposed in order in the horizontal direction (X-direction or Y-direction). In the example, the plurality of interconnection structures L1, L2, and L3 may include the first peripheral interconnection structure L1, the second peripheral interconnection structure L2, and the third peripheral interconnection structure P3, disposed in order in one direction. The plurality of interconnection structures L1, L2, and L3 illustrated in FIG. 1B may be spaced apart from each other in the second direction (Y-direction) and may extend in the first direction (X-direction) as in the drawings, but an example embodiment thereof is not limited thereto, and the plurality of interconnection structures L1, L2, and L3 may be spaced apart from each other in the first direction (X-direction) and may extend in the second direction (Y-direction).

The first peripheral interconnection structure L1 may include a first upper conductive line UPL1, and the third peripheral interconnection structure L3 may include a third upper conductive line UPL3, and the first upper conductive line UPL1 and third upper conductive line UPL3 may be disposed at the same level. Each of the first upper conductive line UPL1 and third upper conductive line UPL3 may be a conductive line extending in the first direction (X-direction).

The first upper conductive line UPL1 and the third upper conductive line UPL3 may be spaced apart from by a first distance Da in the second direction (Y-direction).

The first upper conductive line UPL1 may provide an electrical path in the first direction (X-direction) from a first end of the first upper conductive line UPL1 to a second end opposite the first end of the first upper conductive line UPL1. The third upper conductive line UPL3 may provide an electrical path in the first direction (X-direction) from the first end of the third upper conductive line UPL3 to the second end opposite the first end of the third upper conductive line UPL3.

The second peripheral interconnection structure L2 may be disposed between the first peripheral interconnection structure L1 and the third peripheral interconnection structure L3. In one example embodiment, the second peripheral interconnection structure L2 may include a first peripheral conductive line MPL1 and first and second peripheral patterns MPL2a and MPL2b overlapping the first peripheral conductive line MPL1 in a vertical direction (Z-direction). The first peripheral conductive line MPL1 may be configured as a conductive pattern (or plate) extending in the first direction (X-direction). The first and second peripheral patterns MPL2a and MPL2b may be disposed at the same level as each other and may be spaced apart from each other in the first direction (X-direction).

The intermediate contact plugs MCPa and MCPb may be disposed between the first peripheral conductive line MPL1 and the first and second peripheral patterns MPL2a and MPL2b, and may be part of the second peripheral interconnection structure L2. In one example, the intermediate contact plugs MCPa and MCPb may include a first intermediate contact plug MCPa disposed between the first peripheral conductive line MPL1 and the first peripheral pattern MPL2a, and a second intermediate contact plug MCPb disposed between the first peripheral conductive line MPL1 and the second peripheral pattern MPL2b. In the example, the first intermediate contact plug MCPa may penetrate the third insulating layer ILD32 and may electrically connect the first peripheral conductive line MPL1 to the first peripheral pattern MPL2a, and the second intermediate contact plug MCPb may penetrate the third insulating layer ILD3 and may electrically connect the first peripheral conductive line MPL1 to the second peripheral pattern MPL2b.

The first peripheral conductive line MPL1 may be disposed at a level lower than a level of the first upper conductive line UPL1 and the third upper conductive line UPL3. In one example, the first and second peripheral patterns MPL2a and MPL2b may be disposed at the same level as a level of the first upper conductive line UPL1 and the third upper conductive line UPL3.

The second peripheral interconnection structure L2 may include a first peripheral pattern MPL2a and a second peripheral pattern MPL2b electrically connected to each other through the intermediate contact plugs MCPa and MCPb and the first peripheral conductive line MPL1.

The first peripheral conductive line MPL1 may be disposed at substantially the same level as a level of at least a portion of the first upper conductive pattern PL1 of the cell region CA. In one example, the first peripheral conductive line MPL1 may be disposed at the same level as a level of at least a portion of the first upper conductive pattern PL1 of cell region CA. A side surface of the first peripheral conductive line MPL1 may be surrounded by the second insulating layer ILD2.

The first peripheral conductive line MPL1 may include the first peripheral electrode layer MPL1b on the first peripheral barrier layer MPL1a, and the first peripheral barrier layer MPL1a. In an example, the first peripheral barrier layer MPL1a may include a metal nitride such as titanium nitride (TiN). In an example, the first peripheral electrode layer MPL1b may include at least one of silicon-germanium (SiGe), tungsten (W), tungsten nitride (WN), or titanium nitride (TiN). In an example, the first peripheral conductive line MPL1 may include the same material as that of the first upper conductive pattern PL1. In an example, the first peripheral conductive line MPL1 may have a width decreasing upwardly.

The first and second peripheral patterns MPL2a and MPL2b may be disposed at substantially the same level as a level of at least a portion of the second upper conductive pattern PL2 of cell region CA. In an example, the first and second peripheral conductive patterns MPL2a and MPL2b may be disposed at substantially the same level as a level of the second upper conductive pattern PL2.

The intermediate contact plugs MCPa and MCPb may be disposed at the same level as a level of the upper contact plug CCP in the cell region CA.

The first, second, and third peripheral interconnection structures L1, L2, and L3 may overlap, in the vertical direction (Z-direction), a bit line BL and a bit line capping layer BC extending from the cell region CA.

The semiconductor device 100 may further include peripheral device isolation layers 67 and 69 disposed in the second peripheral region PA2. The peripheral device isolation layers 67 and 69 may extend downwardly from an upper surface of the substrate 3. The peripheral device isolation layers 67 and 69 may surround the active region in substrate 3 and may allow the region to be separated. The peripheral device isolation layers 67 and 69 may include an insulating material.

Referring to FIGS. 1B and 2C, the first peripheral region PA1 of the semiconductor device 100 may include a substrate 3 including a second active region 8, a first peripheral impurity region 5a, and a second peripheral impurity region 5b. The second device isolation layer 7 may be an insulating layer extending downwardly from an upper surface of the substrate 3 and may define the second active region 8. For example, the second active region 8 may correspond to a portion of an upper surface of the substrate 3 surrounded by the second device isolation layer 7. The first peripheral impurity region 5a and the second peripheral impurity region 5b may be spaced apart from each other with the peripheral gate structure GSp therebetween. In example embodiments, the peripheral gate structure GSp may form a peripheral circuit of the semiconductor device 100.

The second device isolation layer 7 may include silicon oxide, silicon nitride, silicon oxynitride, or a combination thereof, and may be formed of a single layer or a plurality of layers. The first and second peripheral impurity regions 5a and 5b may be provided as a source/drain region of a transistor formed by the peripheral gate structure GSp. The first and second peripheral impurity regions 5a and 5b may include impurities having a conductivity type opposite to that of the substrate 3.

The peripheral gate structure GSp may include a peripheral gate dielectric layer 120, peripheral gate layers 125a, 125b, and 125c, and a peripheral capping pattern 128a. The peripheral gate layers 125a, 125b, and 125c may have a structure similar to that of the bit line BL and may be formed of a material similar to that of the bit line BL.

The peripheral gate layers 125a, 125b, and 125c may include a first conductive pattern 125a, a second conductive pattern 125b, and a third conductive pattern 125c stacked in order on the peripheral gate dielectric layer 120 of the substrate 3. The peripheral gate dielectric layer 120 may include silicon oxide, silicon nitride, or a high-κ material. The high-κ material may refer to a dielectric material having a higher dielectric constant than that of silicon oxide. The first conductive pattern 125a, the second conductive pattern 125b and the third conductive pattern 125c of the peripheral gate layers 125a, 125b, and 125c may include the same materials as those of the first conductive layer 25a, the second conductive layer 25b, and the third conductive layer 25c of the bit line BL, respectively. The first peripheral capping pattern 128a may be disposed on the peripheral gate layers 125a, 125b, and 125c. The first peripheral capping pattern 128a may include the same material as that of the first capping layer 28a of the bit line capping layer BC.

The semiconductor device 100 may further include a peripheral gate spacer 129, a second peripheral capping pattern 128b, an interlayer insulating layer 130 and a third peripheral capping pattern 128c in the first peripheral region PA1. The peripheral gate spacer 129 may cover a side surface of the peripheral gate structure GSp. For example, the peripheral gate spacers 129 may be spaced apart from each other with the peripheral gate structure GSp therebetween, and may cover the peripheral gate layers 125a, 125b, and 125c and the first peripheral capping pattern 128a.

The second peripheral capping pattern 128b may cover the substrate 3, the peripheral gate spacer 129, and the peripheral gate structure GSp, and may be formed conformally. The interlayer insulating layer 130 may partially cover the second peripheral capping pattern 128b. An upper surface of the interlayer insulating layer 130 may be coplanar with an upper surface of the second peripheral capping pattern 128b. The third peripheral capping pattern 128c may cover the interlayer insulating layer 130 and the second peripheral capping pattern 128b.

The second peripheral capping pattern 128b and the third peripheral capping pattern 128c may include the same materials as those of the second capping layer 28b and the third capping layer 28c of the bit line capping layer BC, respectively, and may include, for example, silicon nitride. The interlayer insulating layer 130 may include silicon oxide.

The semiconductor device 100 may further include peripheral plugs, including combined layers 162 and 164, and peripheral interconnections, including combined layers 172 and 174 electrically connected to the first and second peripheral impurity regions 5a and 5b in the first peripheral region PA1. The peripheral plugs may penetrate the interlayer insulating layer 130, may be disposed to be adjacent to the peripheral gate structure GSp and may be in contact with the first and second peripheral impurity regions 5a and 5b. The peripheral interconnections may be disposed on the third peripheral capping pattern 128c and peripheral plugs and may extend in the horizontal direction. In an example embodiment, layers of the peripheral interconnections may be integrated with layers of the peripheral plugs. For example, the peripheral interconnection may include the peripheral conductive layer 172 and the peripheral barrier layer 174, and the peripheral plug may include the peripheral conductive layer 162 and the peripheral barrier layer 164. The peripheral barrier layer 164 and peripheral barrier layer 174 may be integrated with each other and may extend vertically and downwardly. The peripheral conductive layer 162 and peripheral conductive layer 172 may be integrated with each other and may extend vertically and downwardly. In some example embodiments, the peripheral interconnections 172 and 174 may not be respectively integrated with the peripheral plugs 162 and 164.

The semiconductor device 100 may further include insulating patterns 165 penetrating the peripheral interconnections 172 and 174. The insulating patterns 165 may spatially isolate the peripheral plugs 162 and 164 and may electrically insulate the peripheral plugs 162 and 164 from each other.

The semiconductor device 100 may further include an etch stop layer 168 disposed on the peripheral interconnections 172 and 174. The etch stop layer 168 may be integrated with the etch stop layer 68. For example, the etch stop layer 168 may be formed by extending the etch stop layer 68 of the cell region CA to the peripheral regions PA1 and PA2.

The semiconductor device 100 may include a peripheral contact plug PCP and a second peripheral conductive line PPL disposed on the peripheral interconnections 172 and 174. The peripheral contact plug PCP may penetrate the first insulating layer ILD1, the second insulating layer ILD2, the third insulating layer ILD3, and the etch stop layer 168 and may be in contact with the peripheral interconnections 172 and 174. The peripheral contact plug PCP may be electrically connected to the first peripheral impurity region 5a or the second peripheral impurity region 5b through the peripheral interconnection 172 and 174 and the peripheral plug 162 and 164. An upper surface of the peripheral contact plug PCP may be coplanar with upper surfaces of the upper contact plug CCP and the third insulating layer ILD3.

The second peripheral conductive line PPL may be disposed on the peripheral contact plug PCP. The second peripheral conductive line PPL may be disposed at substantially the same level as a level of the second upper conductive pattern PL2 of cell region CA. In an example, the second peripheral conductive line PPL may be disposed at the same level as a level of at least a portion of the second upper conductive pattern PL2. The cell region CA and peripheral region PA2 may be arranged so that first and second peripheral patterns MPL2a and MPL2b are disposed between (e.g., physically positioned between) the second upper conductive pattern PL2 and the second peripheral conductive line PPL.

In the semiconductor device 100, dummy structures DPL1, DPL2, and DCP may be disposed in a region adjacent to the peripheral contact plug PCP in the first peripheral region PA1. In the example, the dummy structures DPL1, DPL2, and DCP may include a first dummy conductive pattern DPL1, the second dummy conductive pattern DPL2 on the first dummy conductive pattern DPL1, and a dummy contact plug DCP disposed between the first dummy conductive pattern DPL1 and the second dummy conductive pattern DPL2.

The first dummy conductive pattern DPL1 may be disposed at substantially the same level as a level of the first upper conductive pattern PL1 of the cell region CA. The second dummy conductive pattern DPL2 may be disposed at substantially the same level as a level of the second upper conductive pattern PL2 of the cell region CA. The dummy contact plug DCP may be disposed at substantially the same level as a level of the upper contact plug CCP of the cell region CA. The cell region CA and peripheral region PA2 may be arranged so that the second peripheral conductive line PPL is disposed between the second dummy pattern DPL2 and the second peripheral pattern MPL2b.

The first dummy conductive pattern DPL1 may include a dummy barrier layer DPL1a and a dummy electrode layer DPL1b. The dummy barrier layer DPL1a may be disposed on a lower surface of the dummy electrode layer DPL1b. In the example, a width of the first dummy conductive pattern DPL1 in the horizontal direction may have a width decreasing upwardly.

The first upper conductive pattern PL1, the first peripheral conductive line MPL1 and the first dummy conductive pattern DPL1 may be provided and/or formed by a patterning process.

The dummy structures DPL1, DPL2, and DCP may be in a floating state, and therefore may not be electrically connected to any circuitry for transferring signals or voltage.

The semiconductor device 100 according to an example embodiment may include dummy structures DPL1, DPL2, and DCP, such that defects of contact and corrosion of the peripheral contact plug PCP may be reduced during a process of manufacturing the semiconductor device 100, thereby improving reliability.

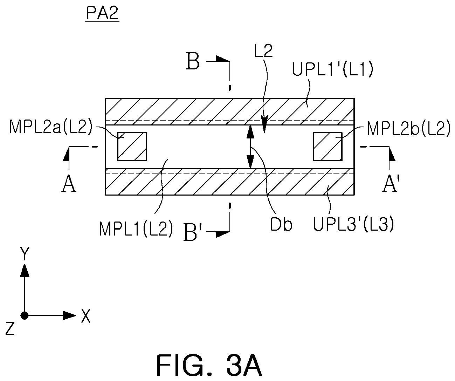

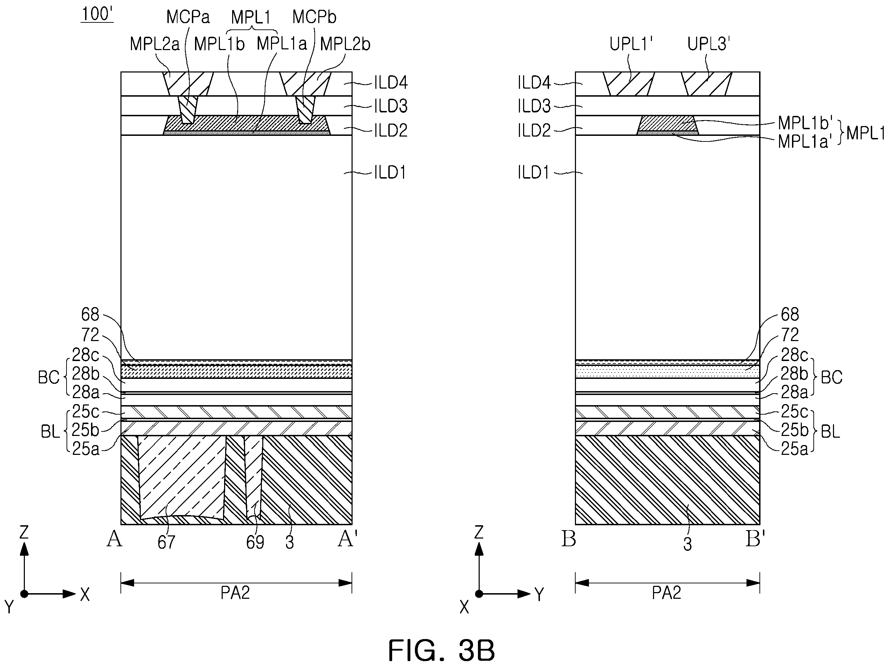

FIG. 3A is a plan diagram illustrating a second peripheral region of a semiconductor device according to another example embodiment. FIG. 3B is cross-sectional diagrams illustrating a second peripheral region taken along lines A-A' and B-B' in FIG. 3A according to an example embodiment.

The components other than the first and third upper conductive lines UPL1' and UPL3' of the semiconductor device 100' illustrated in FIGS. 3A and 3B may be the same as or correspond to the components illustrated in FIGS. 1B and 2B. The overlapping descriptions of the same or corresponding components will not be provided.

The first peripheral interconnection structure L1 may include a first upper conductive line UPL1', the third peripheral interconnection structure L3 may include a third upper conductive line UPL3', and the first upper conductive line UPL1' and the third upper conductive line UPL3' may be disposed on the same level. The first upper conductive line UPL1' and the third upper conductive line UPL3' may be configured as a single conductive line extending in the first direction (X-direction).

The first upper conductive line UPL1' and the third upper conductive line UPL3' may be spaced apart from each other by a second distance (Db) in the second direction (Y-direction).

The first peripheral conductive line MPL1 may overlap at least a portion of the first upper conductive line UPL1' and the third upper conductive line UPL3' in the vertical direction (Z-direction). In this example, a portion of the first upper conductive line UPL1' and a portion of the third upper conductive line UPL3' may overlap the first peripheral conductive line MPL1.

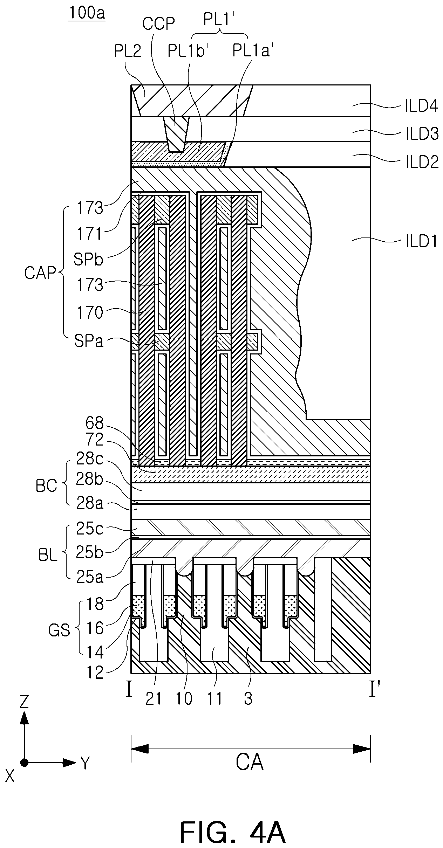

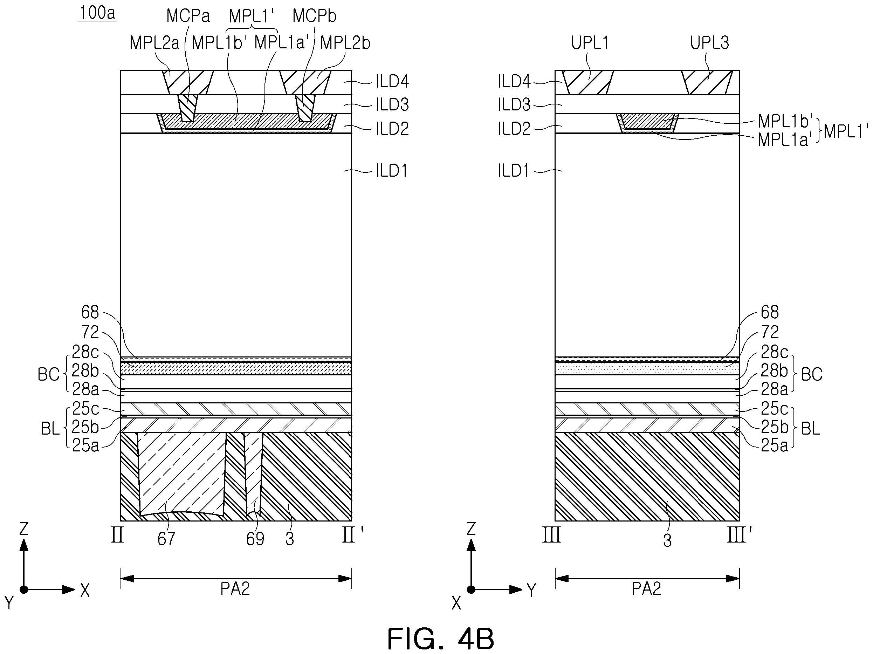

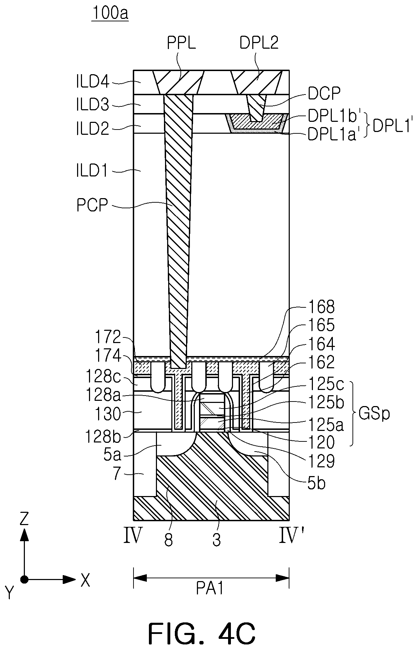

FIGS. 4A to 4C are cross-sectional diagrams illustrating a semiconductor device according to another example embodiment. FIG. 4A is a cross-sectional diagram illustrating the cell region in FIG. 1A taken along line I-I' according to another example embodiment. FIG. 4B is a cross-sectional diagram illustrating the second peripheral region in FIG. 1B taken along lines II-II' and III-III' according to another example embodiment. FIG. 4C is a cross-sectional diagram illustrating the first peripheral region in FIG. 1B taken along line IV-IV' according to another example embodiment.

Referring to FIGS. 4A, 4B, and 4C, the other components other than the first upper conductive pattern PL1', the peripheral conductive line MPL1' and the first dummy conductive pattern DPL1' of the semiconductor device 100a may be the same as or correspond to the components illustrated in FIG. 2A, 2B, and 2C. The overlapping descriptions of the same or corresponding components will not be provided.

The first upper conductive pattern PL1' may include the first barrier layer PL1a' and the first electrode layer PL 1 b'. The first barrier layer PL 1 a' may cover a side surface and a bottom surface of the first electrode layer PL1 b'. In this example, a width of the first upper conductive pattern PL1 ' in the horizontal direction may increase upwardly. In one example, the first electrode layer PL1b' may be referred to as a first interconnection material layer.

The peripheral conductive line MPL1' may include the first peripheral barrier layer MPL1a' and the first peripheral electrode layer MPL1 b'. The first peripheral barrier layer MPL1a' may cover a side surface and a bottom surface of the first peripheral electrode layer MPL1b'. In this example, the peripheral conductive line MPL1' may have a width increasing in the horizontal direction upwardly. In one example, the first peripheral electrode layer MPL1b' may be referred to as a first interconnection material layer.

The first dummy conductive pattern DPL1' may include a dummy barrier layer DPL1a' and a dummy electrode layer DPL1b'. The dummy barrier layer DPL1a' may cover a side surface and a bottom surface of the dummy electrode layer DPL1b'. In this example, a width of the first dummy conductive pattern DPL1' in the horizontal direction may increase upwardly.

The first upper conductive pattern PL1', the peripheral conductive line MPL1' and the first dummy conductive pattern DPL1' may be provided and/or formed by a damascene process.

The peripheral conductive line MPL1' and the first dummy conductive pattern DPL1' may be disposed at substantially the same level as a level of the first upper conductive pattern PL1'.

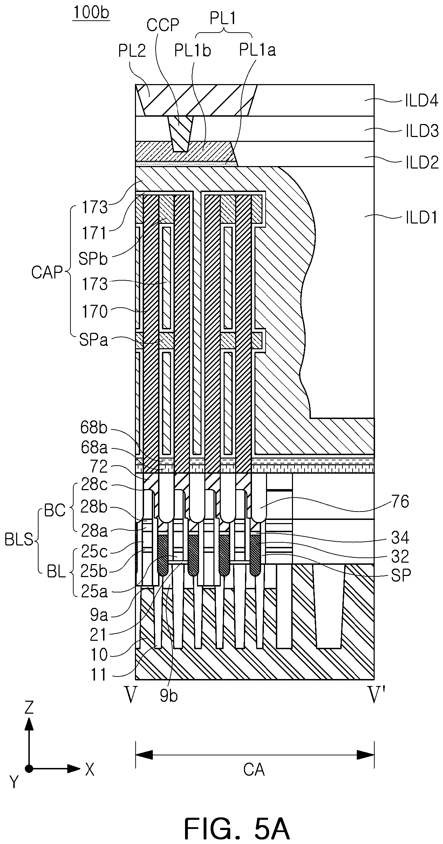

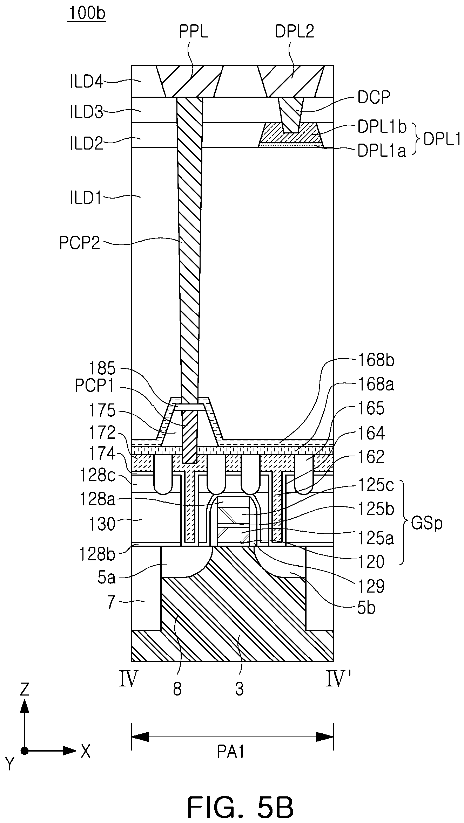

FIGS. 5A and 5B are cross-sectional diagrams illustrating a semiconductor device according to another example embodiment.

FIG. 5A is a cross-sectional diagram illustrating the cell region in FIG. 1A taken along line V-V' according to another example embodiment. FIG. 5B is a cross-sectional diagram illustrating the first peripheral region in FIG. 1B taken along line IV-IV' according to another example embodiment.

Referring to FIGS. 5A and 5B, the components other than the first etch stop layer 68a and 168a, the second etch stop layer 68b and 168b, and the first and second peripheral contact plugs PCP1 and PCP2 of the semiconductor device 100b may be the same as or correspond to the components illustrated in FIG. 2A and 2C. The overlapping descriptions of the same or corresponding components will not be provided.

Referring to FIG. 5A, first and second etch stop layers 68a and 68b may cover insulating patterns 76 between lower electrodes 170. The first etch stop layer 68a may be disposed on the insulating patterns 76, and the second etch stop layer 68b may be disposed on the first etch stop layer 68a.

The second etch stop layer 68b may be in contact with a lower region of side surfaces of the lower electrodes 170. An upper surface of the second etch stop layer 68b may include a portion in contact with the dielectric layer 171. The first and second etch stop layers 68a and 68b may include, for example, at least one of silicon nitride and silicon oxynitride.

The lower electrodes 170 may penetrate the first and second etch stop layers 68a and 68b and may be in contact with the conductive layer 72.

Referring to FIG. 5B, the first etch stop layer 168a may be disposed on peripheral interconnections 172 and 174. The first etch stop layer 168a may be obtained by extending and disposing the first etch stop layer 68a of the cell region CA in the first peripheral region PA1.

The first peripheral contact plug PCP1 may penetrate the first etch stop layer 168a and may be in contact with peripheral interconnections 172. The first peripheral contact plug PCP1 may be electrically connected to the peripheral interconnections 172 and 174.

The peripheral intermediate pad 185 may be disposed on the first peripheral contact plug PCP 1.

A peripheral interlayer insulating layer 175 may be disposed on a side surface of the first peripheral contact plug PCP1. The peripheral interlayer insulating layer 175 may be disposed at a level higher than a level of the first etch stop layer 168a. The peripheral interlayer insulating layer 175 may cover a side surface of the first peripheral contact plug PCP1. The peripheral interlayer insulating layer 175 may be disposed at a level lower than a level of an upper surface of the peripheral intermediate pad 185.

The second etch stop layer 168b may be disposed on the first peripheral contact plug PCP1 and the peripheral intermediate pad 185. The second etch stop layer 168b may be obtained by extending and disposing the second etch stop layer 68b of the cell region CA in the first peripheral region PA1. The second etch stop layer 168b may have a surface profile corresponding to a shape of the peripheral intermediate pad 185 and the peripheral interlayer insulating layer 175.

The second peripheral contact plug PCP2 may be electrically connected to the peripheral intermediate pad 185 by penetrating the first to third insulating layers ILD1-ILD3 and the second etch stop layer 168b. The combined first peripheral contact plug PCP1 and second peripheral contact plug PCP2 may be described together as a contact plug (e.g., including two connected portions).

The second peripheral conductive line PPL may be disposed on the second peripheral contact plug PCP2. In this example, the second peripheral conductive line PPL may be electrically connected to the peripheral circuit through the first and second peripheral contact plugs PCP1 and PCP2.

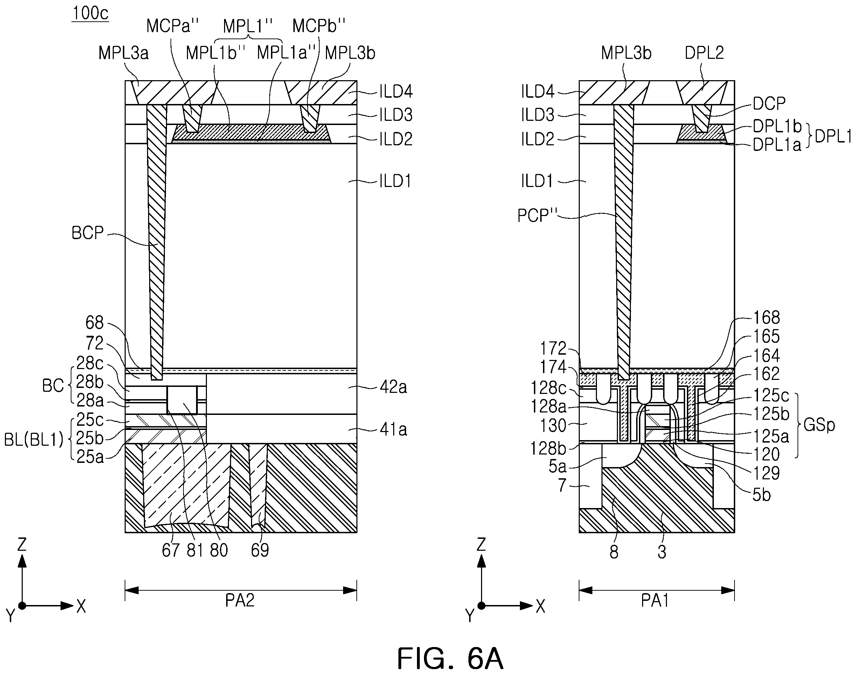

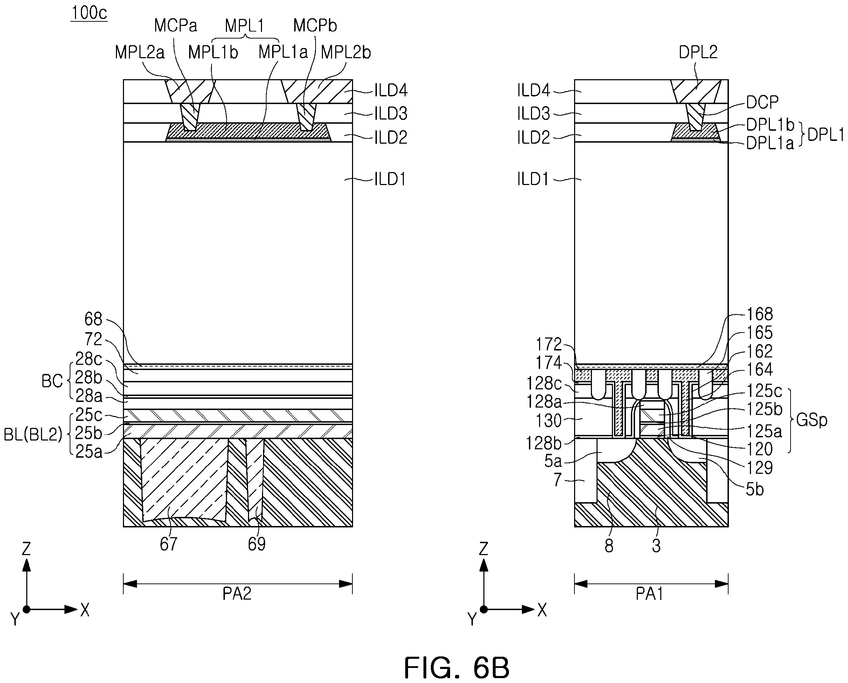

FIGS. 6A and 6B are cross-sectional diagrams illustrating first and second peripheral regions according to an example embodiment.

Referring to FIGS. 6A and 6B, the components other than the bit line contact structure 80 and 81, the bit line contact plug BCP, and the third and fourth peripheral patterns MPL3a and MPL3b of the semiconductor device 100c may be the same as or correspond to the components illustrated in FIGS. 2B and 2C. The overlapping descriptions of the same or corresponding components will not be provided.

Referring to FIGS. 6A and 6B, a semiconductor device 100c may include a first bit line BL1 and a second bit line BL2. The first bit line BL1 and the second bit line BL2 may extend from a cell region (e.g., the cell region CA in FIG. 2A) and may be disposed in the first and second peripheral regions PA1 and PA2, respectively.

The semiconductor device 100c may include bit line contact structures 80 and 81 in the second peripheral region PA2, a first peripheral conductive line MPL1", third and fourth peripheral patterns MPL3a and MPL3b disposed on the first peripheral conductive line MPL1, intermediate contact plug MCPa" and MCPb", and a bit line contact plug BCP. In example embodiments, the first peripheral conductive line MPL1" may include a first peripheral barrier layer MPL1a", and a first peripheral electrode layer MPL1b" on the first peripheral barrier layer MPL1a".

The semiconductor device 100c may further include bit line contact structures 80 and 81. The bit line contact structures 80 and 81 may penetrate the bit line capping layer BC in the second peripheral region PA2 and may be electrically connected to the first bit line BL1.

The bit line contact structures 80 and 81 may include a conductive layer 80 and a barrier layer 81 covering side surfaces and a bottom surface of the conductive layer 80. The conductive layer 80 may include a metal material, for example, tungsten (W). The barrier layer 81 may include at least one of metal nitrides, such as titanium nitride (TiN), tantalum nitride (TaN), and tungsten nitride (WN).

The insulating structures 41a and 42a may be disposed in a portion adjacent to the first peripheral region PA1 in the second peripheral region PA2. The insulating structures 41a and 42a may allow the first bit line BL1 and the peripheral circuit GSp, 5a and 5b to be spaced apart from each other.

The first peripheral conductive line MPL1" may be disposed on the first insulating layer ILD1. The third and fourth peripheral patterns MPL3a and MPL3b may be disposed on the first peripheral conductive line MPL1". The third and fourth peripheral patterns MPL3a and MPL3b may be spaced apart from each other in one direction.

The first peripheral conductive line MPL1" may be disposed at the same level as a level of the first upper conductive pattern PL1 of the cell region CA. In this example, the third and fourth peripheral conductive patterns MPL3a and MPL3b may be disposed at the same level as a level of the second upper conductive pattern PL2 in the cell region CA.

The intermediate contact plugs MCPa" and MCPb" may be disposed between the first peripheral conductive line MPL1" and the third and fourth peripheral patterns MPL3a and MPL3b. In this example, the intermediate contact plugs MCPa" and MCPb" may include a third intermediate contact plug MCPa" disposed between the first peripheral conductive line MPL1" and the third peripheral pattern MPL3a", and a fourth intermediate contact plug MCPb" disposed between the first peripheral conductive line MPL1" and the fourth peripheral pattern MPL3b.

The bit line contact plug BCP may penetrate the first to third insulating layers ILD1-ILD3 and the etch stop layer 68 and may be electrically connected to the third peripheral pattern MPL3a.

The fourth peripheral pattern MPL3b may extend from the second peripheral region PA2 and may be disposed in the first peripheral region PA1. The fourth peripheral pattern MPL3b may be electrically connected to the peripheral circuit GSp, 5a, and 5b through the peripheral contact plug PCP". In another example embodiment, the fourth peripheral pattern MPL3b may be a structure in which a second peripheral pattern (e.g., the second peripheral pattern MPL2b in FIG. 2B) and a second peripheral conductive line (e.g., the second peripheral conductive line PPL in FIG. 2C) are integrated with each other.

The first bit line BL1 may be electrically connected to the peripheral circuit GSp, 5a, and 5b through the bit line contact structure 80 and 81, the bit line contact plug BCP, the first peripheral conductive line MPL1", the third and fourth conductive patterns MPL3a and MPL3b.

Referring to FIG. 6B, the second bit line BL2 may extend from the cell region CA to the second peripheral region PA2 and the first peripheral region PA1 and may be electrically connected to the peripheral circuits GSp, 5a, and 5b.

The bit line contact structure 80 and 81, the bit line contact plug BCP, the first peripheral conductive line MPL1", the third and fourth peripheral patterns MPL3a and MPL3b, and the peripheral contact plug PCP" of the semiconductor device 100c according to the example embodiments may be connection structures to electrically connect the first bit line BL1 to the peripheral circuit GSp, 5a, and 5b.

The semiconductor device 100c according to an example embodiment may include a first bit line BL1 electrically connected to the peripheral circuit GSp, 5a, and 5b through the connection structures, and a second bit line BL2 extending to the first peripheral region PA1 and directly electrically connected to the peripheral circuit GSp, 5a, and 5b.

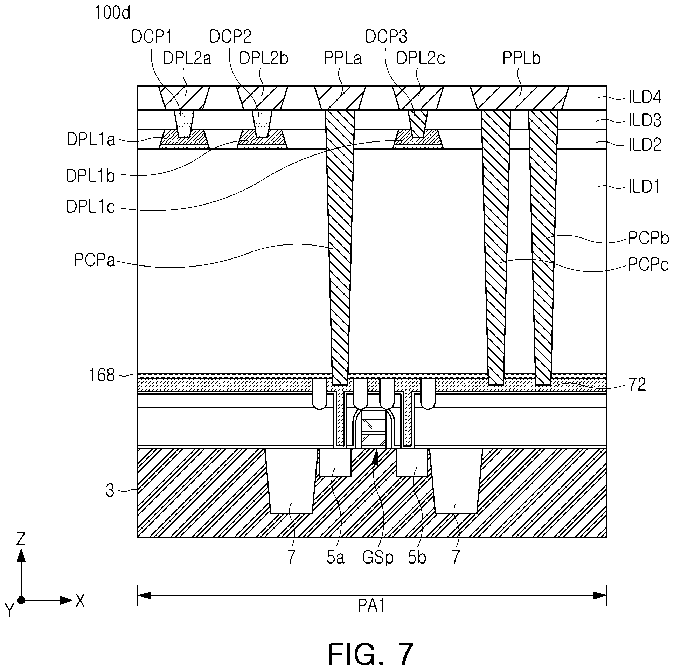

FIG. 7 is a cross-sectional diagram illustrating a first peripheral region of a semiconductor device according to an example embodiment.

Referring to FIG. 7, in the semiconductor device 100d, the components other than a 2-1 peripheral conductive line PPLa, a 2-2 peripheral conductive line PPLb, and first, second, and third peripheral contact plugs PCPa, PCPb, and PCPc may be the same as or correspond to the components illustrated in FIGS. 1B and 2C. The overlapping descriptions of the same or corresponding components will not be provided.

The semiconductor device 100d may include the 2-1 peripheral conductive line PPLa and the 2-2 peripheral conductive line PPLb disposed in the first peripheral region PA1. In the example, the 2-1 peripheral conductive line PPLa may be electrically connected to the peripheral circuit GSp, 5a, and 5b through the first peripheral contact plug PCPa. The 2-2 peripheral conductive line PPLb may be disposed adjacent to an edge of the substrate 3, e.g., to be closer to the edge of the substrate 3 than the 2-1 peripheral conductive line PPLa, and may be electrically connected to conductive layer 72 through the second and third peripheral contact plugs PCPb and PCPc.

The first dummy conductive pattern DPL1a, DPL1b, and DPL1c may be disposed in a region adjacent to the 2-1 peripheral conductive line PPLa and the first peripheral contact plug PCPa. The second dummy conductive patterns DPL2a, DPL2b, and DPL2c may be disposed on the first dummy conductive patterns DPL1a, DPL1b, and DPL1c.

The first dummy conductive pattern DPL1a, DPL1b, and DPL1c may include a 1-1 dummy conductive pattern DPL1a and a 1-2 dummy conductive pattern DPL1b disposed on one side of the 2-1 peripheral conductive line PPLa, and a 1-3 dummy conductive pattern DPL1c disposed between the 2-1 peripheral conductive line PPLa and the 2-2 peripheral conductive line PPLb.

The first dummy conductive patterns DPL1a, DPL1b, and DPL1c may be disposed at the same level as a level of the first upper conductive pattern PL1 of cell region CA, and the second dummy conductive patterns DPL2a, DPL2b, and DPL2c may be disposed at the same level as a level of the second upper conductive pattern PL2 in cell region CA.

Dummy contact plugs DCP1, DCP2, and DCP3 connecting the first dummy conductive patterns DPL1a, DPL1b, and DPL1c to the second dummy conductive patterns DPL2a, DPL2b, and DPL2c may be disposed between the first dummy conductive pattern DPL1a, DPL1b, and DPL1c and the second dummy conductive pattern DPL2a, DPL2b, and DPL2c. The first dummy contact plug DCP1 may be disposed between the 1-1 dummy conductive pattern DPL1a and the 2-1 dummy conductive pattern DPL2a. The second dummy contact plug DCP2 may be disposed between the 1-2 dummy conductive pattern DPL1b and the 2-2 dummy conductive pattern DPL2b. The third dummy contact plug DCP3 may be disposed between the 1-3 dummy conductive pattern DPL1c and the 2-3 dummy conductive pattern DPL2c.

The first dummy conductive patterns DPL1a, DPL1b, and DPL1c and the second dummy conductive patterns DPL2a, DPL2b, and DPL2c may be disposed in a region having relatively low interconnection density or in a region adjacent to an edge of the substrate 3.

The first dummy conductive patterns DPL1a, DPL1b, and DPL1c and the second dummy conductive patterns DPL2a, DPL2b, and DPL2c may be formed in a region adjacent to the 2-1 peripheral conductive line PPLa and the first peripheral contact plug PCPa, such that a defect in which the first peripheral contact plug PCPa is not open during the process of forming the first peripheral contact plug PCPa in the process of manufacturing the semiconductor device 100d may be addressed.

As the 1-3 dummy conductive pattern DPL1c and 2-3 dummy conductive pattern DPL2c are disposed in a region adjacent to the plurality of peripheral contact plugs PCPb and PCPc, the 1-3 dummy conductive patternDPLIc and the 2-3 dummy conductive patternDPL2c may prevent corrosion of contact plugs disposed on edges of the plurality of peripheral contact plugs PCPb and PCPc during the manufacturing process. Accordingly, by including the first dummy conductive patterns DPL1a, DPL1b, and DPL1C and the second dummy conductive patterns DPL2a, DPL2b, and DPL2c according to example embodiments, a semiconductor device having improved reliability may be provided.

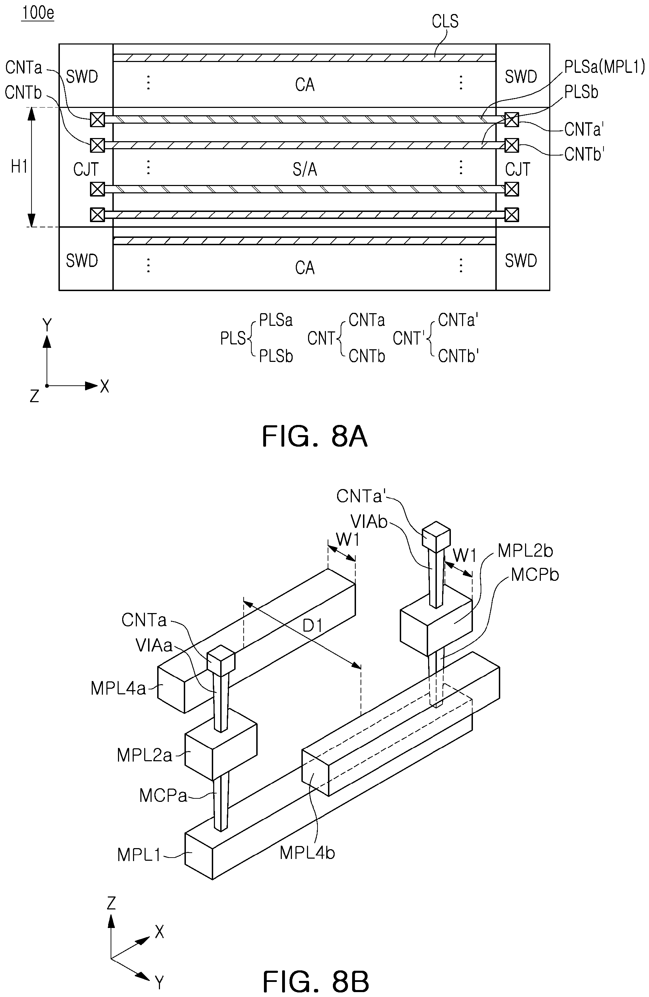

FIG. 8A is a plan diagram illustrating a cell connection structure disposed in a cell region of a semiconductor device and a peripheral connection structure disposed in peripheral regions according to an example embodiment. FIG. 8B is a perspective diagram illustrating peripheral connection structures illustrated in FIG. 8A according to an example embodiment.

Referring to FIG. 8A, a semiconductor device 100e may include a cell region CA and peripheral regions (e.g., the peripheral regions PA1 and PA2 in FIG. 1B), and in the peripheral regions PA1 and PA2, a plurality of sub-wordline driver blocks SWD may be arranged in the direction in which the wordline extends, and a sense amplifier block (S/A) may be arranged in the direction in which the bit line extends.

A conjunction block CJT may be arranged at a point at which the sub-wordline driver block SWD and the sense amplifier block (S/A) intersect. Power drivers and ground drivers for driving the bit line sense amplifier may be alternately disposed in the conjunction block CJT.

Referring to FIG. 8A, cell interconnection structures CLS extending in the first direction (X-direction) may be disposed on the cell region CA. In an example, the peripheral interconnection structures PLS passing through the sense amplifier block (S/A) and electrically connecting the conjunction blocks CJT to each other may be disposed on the peripheral regions (e.g., the peripheral regions PA1 and PA2 in FIG. 1B).

The peripheral interconnections structures PLS may include a plurality of peripheral interconnections spaced apart from each other in the second direction (Y-direction). In an example, the peripheral interconnection structures PLS may extend in the same direction as that of the cell interconnection structure CLS. However, an embodiment thereof is not limited thereto. For example, the peripheral interconnection structures PLS may extend in the first direction (X-direction) or the second direction (Y-direction).

Each of the peripheral interconnection structures PLS may be electrically connected to a first contact hole CNT connected to the conjunction block CJT disposed on one side of the sense amplifier block (S/A), and a second contact hole CNT connected to the conjunction block CJT disposed on the other side of the sense amplifier block (S/A).

The peripheral interconnection structures PLS may include a first peripheral interconnection structure PLSa and a second peripheral interconnection structure PLSb spaced apart from the first peripheral interconnection structure PLSa.

The first peripheral interconnection structure PLSa may be electrically connected to the first contact hole CNTa and the second contact hole CNTa' electrically connecting the conjunction blocks CJT disposed on both sides of the sense amplifier block (S/A) to each other. The first peripheral interconnection structure PLSa may include multiple conductive lines including the first peripheral conductive line MPL1 and the multiple conductive lines above, and may form a signal path with via holes VIAa and VIAb.

The second peripheral interconnection structure PLSb may be electrically connected to the first contact hole CNTb and the second contact hole CNTb' electrically connecting the conjunction blocks CJT disposed on both sides of the sense amplifier block (S/A) to each other. The second peripheral interconnection structure PLSb may form a signal path with a single conductive line (or a pattern) and the via holes VIAa and VIAb connected to the single conductive line.

The first peripheral interconnection structure PLSa and the second peripheral interconnection structure PLSb may be disposed alternately. However, an example embodiment thereof is not limited thereto, and the arrangement of the peripheral interconnection structures PLS may be varied.

FIG. 8B illustrates an example electrical connection relationship between the second peripheral interconnection structures PLSb and the first peripheral interconnection structure PLSa disposed between the second peripheral interconnection structures PLSb.

The first peripheral conductive line MPL1 and the first upper peripheral line MPL4a and the second upper peripheral line MPL4b spaced apart from each other in the second direction (Y-direction) may form a second peripheral interconnection structure PLSb. In example embodiments, the first upper peripheral line MPL4a and the second upper peripheral line MPL4b may be referred to together as a third peripheral conductive line.

The first peripheral conductive line MPL1 and the first and second peripheral patterns MPL2a and MPL2b may be disposed between the first upper peripheral line MPL4a and the second upper peripheral line MPL4b. In this example, the first upper peripheral line MPL4a and the second upper peripheral line MPL4b may extend in the first direction (X-direction), and may be spaced apart from each other in the first and second peripheral patterns MPL2a and MPL2b in the second direction (Y-direction).

The intermediate contact plugs MCPa and MCPb may connect the first peripheral conductive line MPL1 to the first and second peripheral patterns MPL2a and MPL2b, and the first peripheral conductive line MPL1 and the first and second peripheral patterns MPL2a and MPL2b may form a first peripheral interconnection structure PLSa.

The first and second upper peripheral lines MPL4a and MPL4b may be disposed at the same level as a level of the first and second peripheral patterns MPL2a and MPL2b.

A length of the first and second upper peripheral lines MPL4a and MPL4b in the first direction (X-direction) may be equal to or smaller than a spacing distance in the first direction (X-direction) between the first and second peripheral patterns MPL2a and MPL2b. In an example, the first and second upper peripheral lines MPL4a and MPL4b may not overlap the first and second peripheral patterns MPL2a and MPL2b in the second direction (Y-direction).

The first peripheral conductive line MPL1 may be disposed at a level lower than a level of the first and second upper peripheral lines MPL4a and MPL4b in the vertical direction.

The first upper peripheral line MPL4a (or the second upper peripheral line MP4b) may be electrically connected to the conjunction block CJT through a single interconnection.

Electrical signals of the first and second peripheral patterns MPL2a and MPL2b may be connected to each other through the intermediate contact plugs MCPa and MCPb and the first peripheral conductive line MPL1.

The first peripheral conductive line MPL1, and the first and second upper peripheral lines MPL4a and MPL4b may have a first width W1 in the second direction (Y-direction).

In the semiconductor device 100e, a width of the sense amplifier block (S/A) in which the peripheral interconnection structures PLS is disposed may be a first width H1. The first and second upper peripheral lines MPL4a and MPL4b may be spaced apart from each other by the first length D1 in the second direction (Y-direction) with the first and second peripheral patterns MPL2a and MPL2b interposed therebetween.

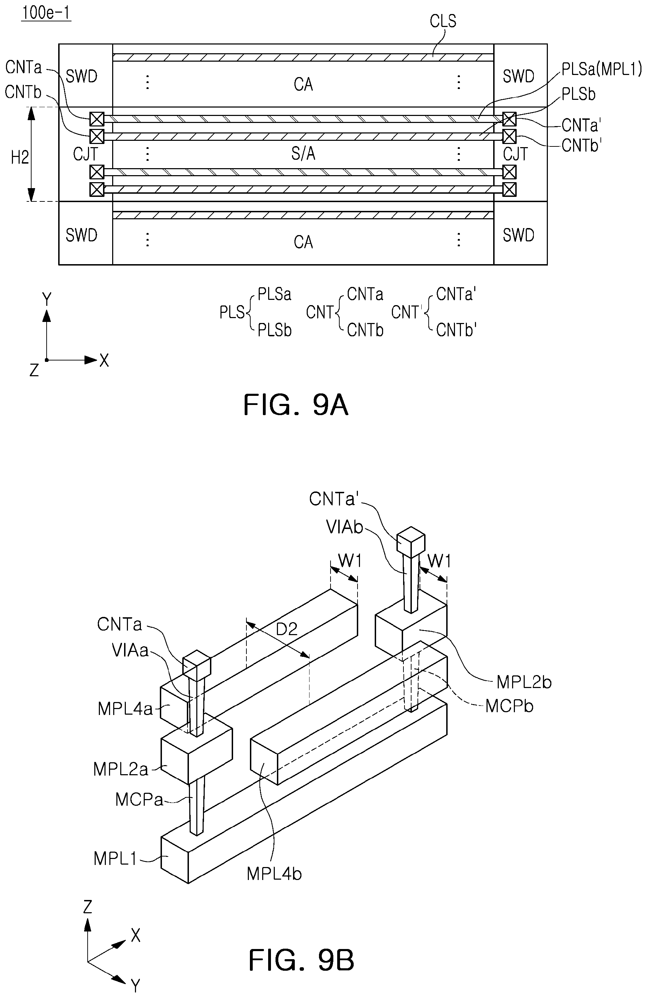

FIG. 9A is a plan diagram illustrating a cell connection structure disposed in a cell region of a semiconductor device and a peripheral connection structure disposed in peripheral regions according to an example embodiment. FIG. 9B is a perspective diagram illustrating peripheral connection structures in FIG. 9A according to an example embodiment.

Referring to FIGS. 9A and 9B, in the semiconductor device 100e-1, a width of the sense amplifier block (S/A) in which the peripheral interconnection structures PLS is disposed may have a second width H2. The first and second upper peripheral lines MPL4a and MPL4b may be spaced apart from each other by the second length D2 in the second direction (Y-direction) with the first and second peripheral patterns MPL2a and MPL2b interposed therebetween.

Referring to FIGS. 8A and 9A, a second width H2 of the sense amplifier block (S/A) of the semiconductor device 100e-1 may be less than the first width H1 of the sense amplifier block (S/A) of the semiconductor device 100e. A region of the sense amplifier block (S/A) in which the peripheral interconnection structures PLS is disposed in the semiconductor device 100e-1 may be smaller than a region of the sense amplifier block (S/A) in which the peripheral interconnection structures PLS is disposed in the semiconductor device 100e. By moving one of the peripheral lines (MPL1) to be at a level lower than the other peripheral lines MPL4a and MPL4b, all of these lines can be closer together to each other in the Y-direction (as viewed from a plan view) without the likelihood of short circuiting or interfering with each other.

Therefore, the semiconductor device according to example embodiments may reduce the width of the sense amplifier block (S/A) in the horizontal direction (Y-direction) by forming an electrical path through the first peripheral interconnection structure PLSa, thereby improving integration density of the semiconductor device.

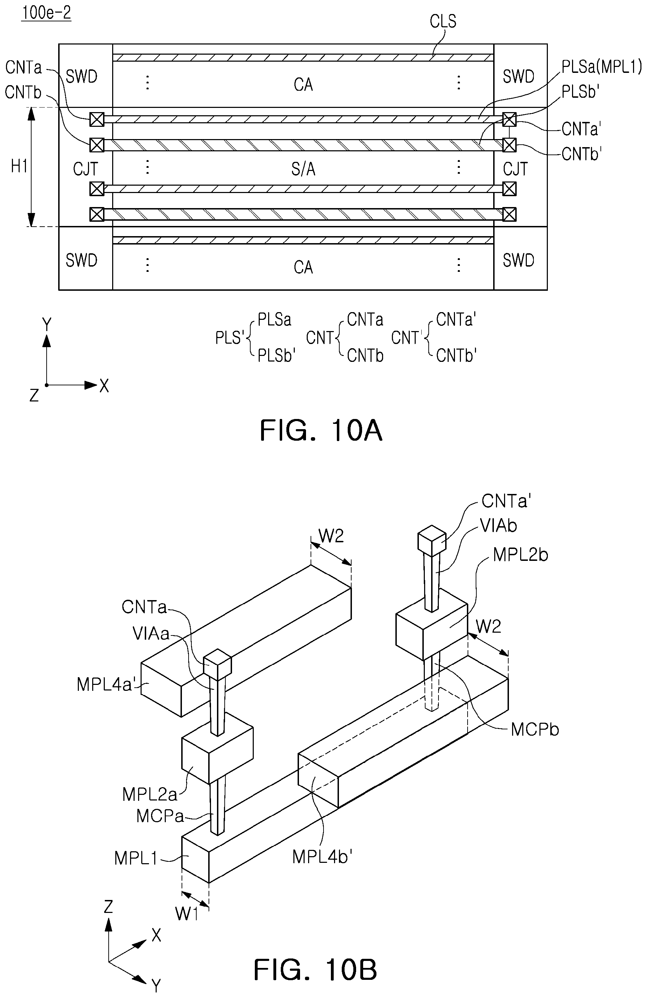

FIG. 10A is a plan diagram illustrating a cell connection structure disposed in a cell region of a semiconductor device and a peripheral connection structure disposed in peripheral regions according to an example embodiment. FIG. 10B is a perspective diagram illustrating peripheral connection structures in FIG. 10A according to an example embodiment.

Referring to FIGS. 10A and 10B, a semiconductor device 100e-2 may include a peripheral interconnection structure PLS'. The peripheral interconnection structure PLS' may include a first peripheral interconnection structure PLSa and a second peripheral interconnection structure PLSb' spaced apart from each other the first peripheral interconnection structure PLSa.

Referring to FIG. 10B, an electrical connection relationship of the first peripheral interconnection structure PLSa disposed between the second peripheral interconnection structures PLSb' and the second peripheral interconnection structures PLSb' is shown.

Each of the first upper peripheral line MPL4a' and the second upper peripheral line MPL4b' may form a second peripheral interconnection structure PLSb'.

The semiconductor device 100e-2 may include a first peripheral conductive line MPL1 having a first width W1 and first and second upper peripheral lines MPL4a' and MPL4b' having a second width W2 greater than the first width W1.

In the semiconductor device 100e-2 according to example embodiments, the first and second peripheral patterns MPL2a and MPL2b may be spaced apart from each other in the first direction (X-direction) and may be electrically connected to each other through the first peripheral conductive line MPL1, such that the space in which interconnection is disposed may be ensured through a spacing between the first and second peripheral patterns MPL2a and MPL2b. In this example, the first and second peripheral patterns MPL2a and MPL2b may have a width greater than a width of the first peripheral conductive line MPL1 in the second direction (Y-direction).

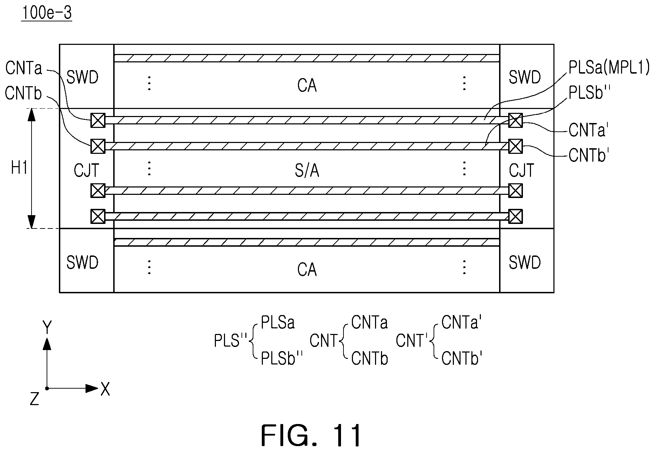

FIG. 11 is a plan diagram illustrating a cell connection structure disposed in a cell region of a semiconductor device and a peripheral connection structure disposed in peripheral regions according to an example embodiment.

Referring to FIG. 11, peripheral interconnection structures PLS" may include a first peripheral interconnection structure PLSa and a second peripheral interconnection structure PLSb" spaced apart from the first peripheral interconnection structure PLSa.

The second peripheral interconnection structure PLSb" may have the same structure as that of the first peripheral interconnection structure PLSa. The first peripheral interconnection structure PLSa and the second peripheral interconnection structure PLSb" may correspond to the first contact hole CNTa and CNTb and the second contact hole CNTa' and CNTb' electrically connecting the conjunction blocks CJT disposed on both sides of the sense amplifier block (S/A) to each other. The first peripheral interconnection structure PLSa and the second peripheral interconnection structure PLSb" may include multiple conductive lines including the first peripheral conductive line MPL1 and the multiple conductive lines, and may form an electrical path along with via holes VIAa and VIAb.

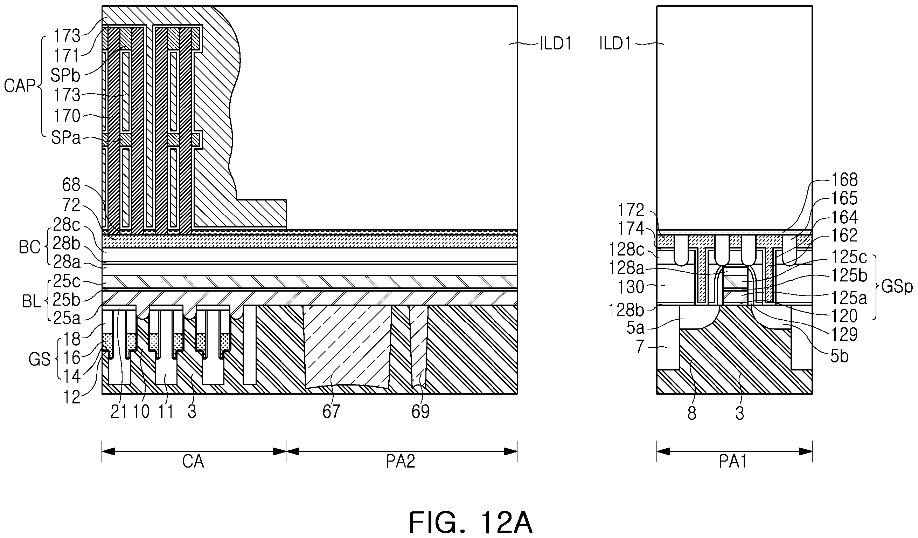

FIGS. 12A to 12D are diagrams illustrating a method of manufacturing a semiconductor device according to an example embodiment.

Referring to FIG. 12A, a capacitor CAP may be formed on an etch stop layer 68 of substrate 3 formed in the cell region CA. An interlayer insulating layer ILD1 may be formed on a side surface of the capacitor CAP on the substrate 3. In an example, the interlayer insulating layer ILD1 may be formed on an external side surface of the upper electrode 173. In one example, the interlayer insulating layer ILD1 may be formed on an outer surface of the upper electrode 173. The interlayer insulating layer ILD1 may not cover an upper surface (e.g., topmost, vertical-facing surface) of the upper electrode 173.

The upper surface (e.g., a topmost surface) of upper electrode 173 may be formed at the same level as a level of an upper surface (e.g., a topmost surface) of the interlayer insulating layer ILD1. In an example, as a CMP process may be performed on the upper electrode 173 and the interlayer insulating layer ILD1 to planarize the interlayer insulating layer ILD1 across the cell region CA and the first and second peripheral regions PA1 and PA2, an upper surface of the upper electrode 173 may be on the same level as a level of an upper surface of the interlayer insulating layer ILD1.

The cell gate structure GS, the bit line BL, and the bit line capping layer BC may be formed below the etch stop layer 68.

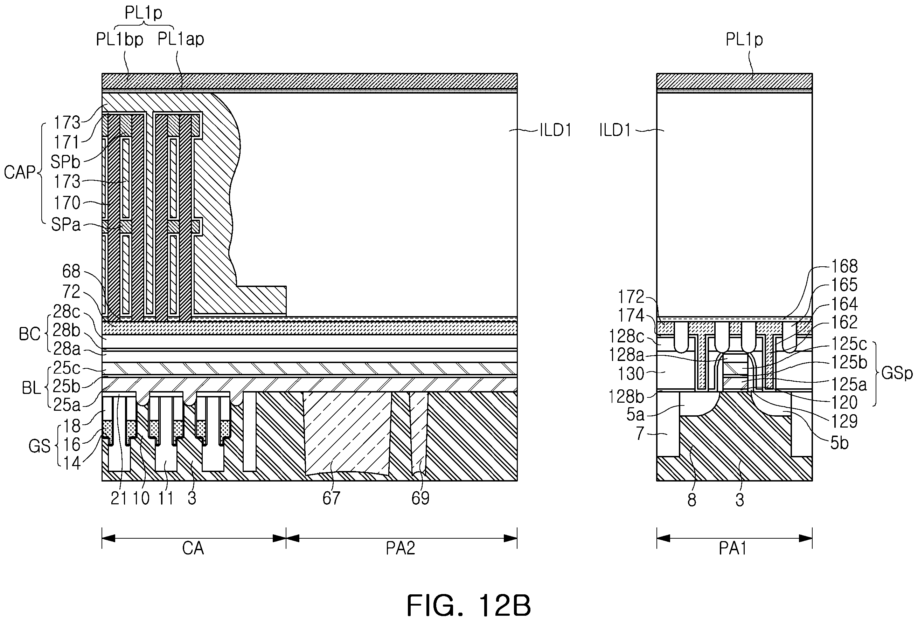

Referring to FIG. 12B, a first plate PL1p may be formed on the upper electrode 173 and the interlayer insulating layer ILD1 throughout the cell region CA and the first and second peripheral regions PA1 and PA2. In an example, the first plate PL1p may include a first preliminary barrier layer PL1ap and a first preliminary electrode layer PL1bp formed on the first preliminary barrier layer PL1ap.

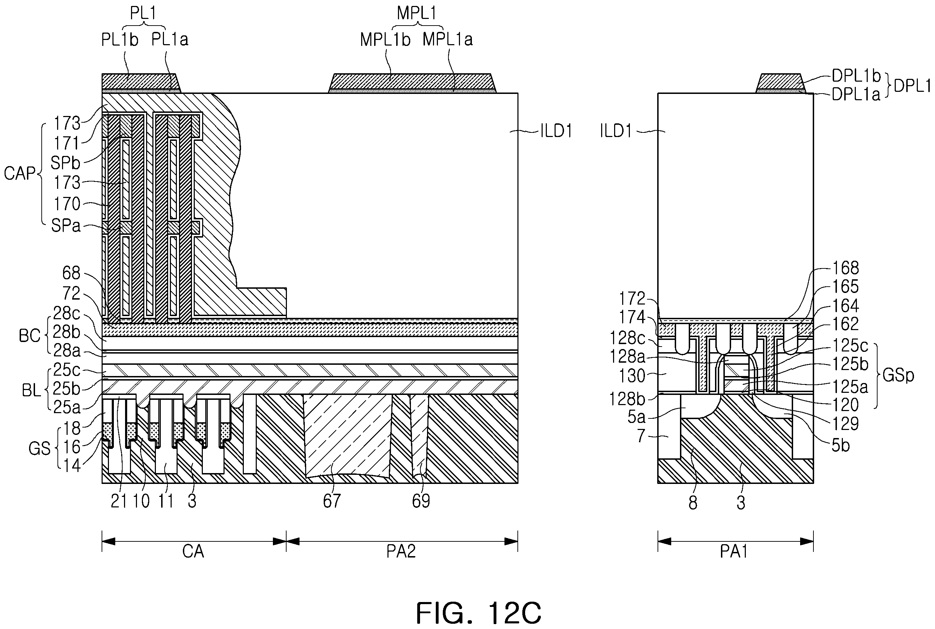

Referring to FIG. 12C, by removing a portion of the first plate PL1p, a first upper conductive pattern PL1 on the cell region CA, a first dummy conductive pattern DPL1 on the first peripheral region PA1, and a first peripheral conductive line MPL1 on the second peripheral region PA2 may be formed.

By removing a portion of the first preliminary barrier layer PL1ap and the first preliminary electrode layer PL 1 bp by exposing a portion of the first plate PL1p using a mask layer (not illustrated), a first upper conductive pattern PL1, a first dummy conductive pattern DPL1, and a first peripheral conductive line MPL1 may be formed. The mask layer may be configured as a hard mask layer. The first upper conductive pattern PL1, the first dummy conductive pattern DPL1, and the first peripheral conductive line MPL1 may be spaced apart from each other in one direction. In the example, the first dummy conductive pattern DPL1 and the first peripheral conductive line MPL1 may be formed in the same process as a process of forming the first upper conductive pattern PL1. In the example, the first upper conductive pattern PL1, the first dummy conductive pattern DPL1, and the first peripheral conductive line MPL1 may be formed at substantially the same level.

An upper surface of the upper electrode 173 may be covered by the first upper conductive pattern PL1 and may not be exposed. The first upper conductive pattern PL1 may be formed on an upper surface of the upper electrode 173 and may contact the upper electrode 173.

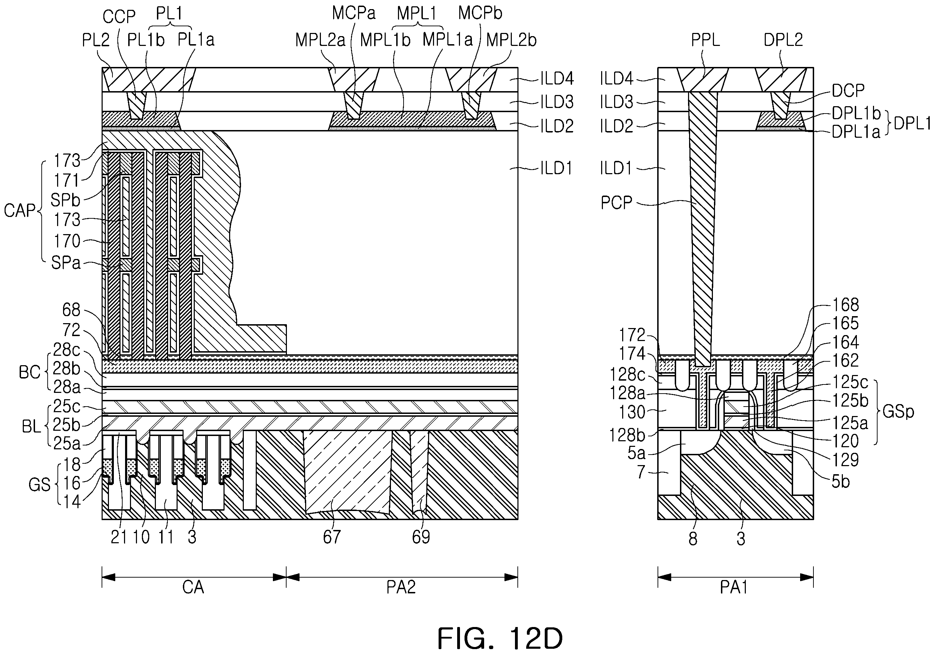

Referring to FIG. 12D, a second insulating layer ILD2 filling a spacing between the first upper conductive pattern PL1, the first dummy conductive pattern DPL1, and the first peripheral conductive line MPL1 may be formed. A third insulating layer ILD3 may be formed on the first upper conductive pattern PL1, the first dummy conductive pattern DPL1, and the first peripheral conductive line MPL1.

An upper contact plug CCP may be formed on the first upper conductive pattern PL1. intermediate contact plugs MCPa and MCPb may be formed on the first peripheral conductive line MPL1. A dummy contact plug DCP may be formed on the first dummy conductive pattern DPL1. In this example, an upper surface of the upper contact plug CCP, the intermediate contact plugs MCPa and MCPb, and the dummy contact plug DCP may be coplanar with an upper surface of the third insulating layer ILD3.

A second upper conductive pattern PL2 may be formed on the upper contact plug CCP. The first and second peripheral patterns MPL2a and MPL2b may be formed on the intermediate contact plugs MCPa and MCPb. A second dummy conductive pattern DPL2 may be formed on the dummy contact plug DCP. In this example, the second upper conductive pattern PL2, the first and second peripheral patterns MPL2a and MPL2b, and the second dummy conductive pattern DPL2 may be formed through the same process.

In the method of manufacturing a semiconductor device according to an example embodiment, in a process of forming the first and second upper conductive patterns PL1 and PL2 on the cell region CA, a first peripheral conductive line MPL1 and first and second peripheral patterns MPL2a and MPL2b may be formed on the second peripheral region PA2. Also, the first and second peripheral patterns MPL2a and MPL2b may provide an electrical path with the first peripheral conductive line MPL1 disposed below the first and second peripheral patterns MPL2a and MPL2b, thereby reducing the number of processes and ensuring an efficient interconnection space.

Also, dummy pattern structures DPL1, DPL2, and DCP may be disposed on the first peripheral region PA1, and the dummy pattern structures DP1, DPL2, and DCP may be a structure formed in the process of forming the first upper conductive pattern PL1 and the second upper conductive pattern PL2, and the dummy pattern structures DP1, DPL2, and DCP may address corrosion of the peripheral contact plug PCP and the poor electrical connection with a peripheral circuit, such that a semiconductor device having improved reliability may be provided.

According to the aforementioned example embodiments, in the semiconductor device including a capacitor, as the peripheral conductive pattern disposed in the peripheral region adjacent to the cell region provides an electrical path together with the first and second peripheral patterns disposed on the peripheral conductive pattern, the semiconductor device having increased integration density may be provided.

Also, in the semiconductor device including a capacitor, by including the dummy patterns disposed to be adjacent to the peripheral contact plugs connected to the peripheral circuit, damage to the peripheral contact plugs during the manufacturing process may be addressed such that a semiconductor device having increased reliability may be provided.

Embodiments are set out in the following clauses:
Clause 1. A semiconductor device, comprising: a substrate including a first region and a second region; a capacitor on the substrate in the first region, wherein the capacitor includes a lower electrode, supporter layers connected to the lower electrode, a dielectric layer covering the supporter layers and the lower electrode, and an upper electrode on the dielectric layer; a first upper conductive pattern in contact with an upper surface of the upper electrode; a second upper conductive pattern on the first upper conductive pattern; an upper contact plug between the first upper conductive pattern and the second upper conductive pattern; an interlayer insulating layer disposed on the second region of the substrate and disposed on an outer surface of the upper electrode; and a first peripheral conductive line disposed on the interlayer insulating layer and disposed at the same vertical level as a vertical level of at least a portion of the first upper conductive pattern.
Clause 2. The semiconductor device of clause 1, further comprising: a first peripheral pattern and a second peripheral pattern disposed on the first peripheral conductive line and spaced apart from each other; and intermediate contact plugs respectively disposed between each pattern of the first and second peripheral patterns and the first peripheral conductive line, wherein the first and second peripheral patterns are disposed at the same vertical level as a vertical level of at least a portion of the second upper conductive pattern.
Clause 3. The semiconductor device of clause 2, wherein the second upper conductive pattern extends in the first direction, and wherein the first and second peripheral patterns are spaced apart from each other in a first direction.
Clause 4. The semiconductor device of clause 2 or 3, wherein the second region is between the first region and an edge of the substrate and is adjacent to the edge of the substrate.
Clause 5. The semiconductor device of clause 2, 3 or 4, further comprising: a second peripheral conductive line disposed on the second region of the substrate and disposed at the same vertical level as a vertical level of the second upper conductive pattern; a peripheral contact plug penetrating the interlayer insulating layer, extending upwardly, and connected to the second peripheral conductive line; and a peripheral circuit disposed at a vertical level lower than a vertical level of the interlayer insulating layer and electrically connected to the peripheral contact plug.
Clause 6. The semiconductor device of clause 5, further comprising: a first etch stop layer disposed on the peripheral circuit; and a second etch stop layer disposed on the first etch stop layer, wherein the peripheral contact plug further includes: a first peripheral contact plug having an external side surface covered by the second etch stop layer, penetrating the first etch stop layer, and electrically connected to the peripheral circuit; and a second peripheral contact plug penetrating the interlayer insulating layer and the second etch stop layer and electrically connected to the first peripheral contact plug.
Clause 7. The semiconductor device of clause 5 or 6, wherein the first and second peripheral patterns are disposed between the second upper conductive pattern and the second peripheral conductive line.
Clause 8. The semiconductor device of clause 5, 6 or 7, further comprising: a dummy structure disposed on one side of the second peripheral conductive line and configured to be in a floating state, wherein the dummy structure includes: a first dummy pattern in the second region and disposed at the same vertical level as a vertical level of the first peripheral conductive line; a second dummy pattern disposed at the same vertical level as a vertical level of the second peripheral conductive line and overlapping the first dummy pattern in a vertical direction; and a dummy contact plug connecting the first dummy pattern to the second dummy pattern, wherein the second peripheral conductive line is disposed between the second dummy pattern and the second peripheral pattern.
Clause 9. The semiconductor device of any of clauses 5 to 8, further comprising: a bit line disposed at a vertical level lower than a vertical level of the capacitor and the interlayer insulating layer; a bit line contact structure electrically connected to the bit line extending to the second region; and a bit line contact plug penetrating the interlayer insulating layer from the bit line contact structure disposed below the interlayer insulating layer, extending upwardly, and connected to the first peripheral pattern.
Clause 10. The semiconductor device of clause 9, wherein the second peripheral pattern and the second peripheral conductive line are integrated with each other.
Clause 11. The semiconductor device of any preceding clause, wherein an upper surface of the interlayer insulating layer is disposed at the same vertical level as a vertical level of the upper surface of the upper electrode.
Clause 12. The semiconductor device of any preceding clause, wherein the first upper conductive pattern and the first peripheral conductive line include a first interconnection material layer and a first barrier layer covering a side surface and a bottom surface of the first interconnection material layer.
Clause 13. The semiconductor device of any preceding clause, wherein the first upper conductive pattern includes at least one of tungsten (W) and silicon-germanium (SiGe), and wherein the second upper conductive pattern includes copper (Cu).
Clause 14. A semiconductor device, comprising: a substrate including a cell region including a bit line and a memory structure disposed at a vertical level higher than a vertical level of the bit line, and a peripheral region including peripheral circuits; a first upper conductive pattern disposed on the memory structure on the cell region; a second upper conductive pattern on the first upper conductive pattern; a first peripheral conductive line extending in a first direction on the peripheral region and disposed at the same vertical level as a vertical level of at least a portion of the first upper conductive pattern; a first peripheral pattern and a second peripheral pattern disposed on the first peripheral conductive line at the same vertical level as a vertical level of at least a portion of the second upper conductive pattern and spaced apart from each other in the first direction; a first intermediate contact plug disposed between the first peripheral conductive line and the first peripheral pattern; and a second intermediate contact plug disposed between the first peripheral conductive line and the second peripheral pattern.
Clause 15. The semiconductor device of any preceding clause, further comprising: a second peripheral conductive line disposed at the same vertical level as a vertical level of the first and second peripheral patterns on the peripheral region, disposed side by side with the first and second peripheral patterns in a second direction intersecting with the first direction, and extending in the first direction.
Clause 16. The semiconductor device of any preceding clause, wherein a width of the second peripheral conductive line in the second direction is greater than a width of the first peripheral conductive line in the second direction.
Clause 17. The semiconductor device of any preceding clause, wherein at least a portion of the second peripheral conductive line overlaps the first peripheral conductive line in a vertical direction.
Clause 18. A semiconductor device, comprising: a substrate including a cell region and a peripheral region surrounding the cell region; a bit line disposed on the cell region; a capacitor disposed on the cell region and disposed at a vertical level higher than a vertical level of the bit line, wherein the capacitor includes a lower electrode structure of a plurality of lower electrode structures, supporter layers adjacent to the lower electrode structure and which are part of supporter layers formed between the lower electrode structures of the plurality of lower electrode structures, a dielectric layer covering the lower electrode structure and which also covers the plurality of lower electrode structures, and an upper electrode on the dielectric layer; a first upper conductive pattern in contact with and vertically above an upper surface of the upper electrode; a second upper conductive pattern on the first upper conductive pattern; an upper contact plug electrically connecting the first upper conductive pattern to the second upper conductive pattern; a first interlayer insulating layer disposed on the substrate of the peripheral region and disposed on an external side surface of the upper electrode; a first peripheral conductive line disposed on the first interlayer insulating layer and disposed at the same vertical level as a vertical level of at least a portion of the first upper conductive pattern; a first peripheral pattern and a second peripheral pattern disposed at the same vertical level as a vertical level of at least a portion of the second upper conductive pattern on the first peripheral conductive line, and spaced apart from each other; and intermediate contact plugs respectively disposed between each of the first and second peripheral patterns and the first peripheral conductive line.
Clause 19. The semiconductor device of clause 18, wherein the first interlayer insulating layer is in contact with an external side surface of the upper electrode and exposes an upper surface of the upper electrode.
Clause 20. The semiconductor device of clause 18 or 19, wherein the first and second peripheral patterns overlap the first peripheral conductive line in a vertical direction.

While the example embodiments have been illustrated and described above, it will be configured as apparent to those skilled in the art that modifications and variations may be made without departing from the scope as defined by the appended claims.

## Claims

1. A semiconductor device, comprising:
a substrate including a first region and a second region;
a capacitor on the substrate in the first region, wherein the capacitor includes a lower electrode, supporter layers connected to the lower electrode, a dielectric layer covering the supporter layers and the lower electrode, and an upper electrode on the dielectric layer;
a first upper conductive pattern in contact with an upper surface of the upper electrode;
a second upper conductive pattern on the first upper conductive pattern;
an upper contact plug between the first upper conductive pattern and the second upper conductive pattern;
an interlayer insulating layer disposed on the second region of the substrate and disposed on an outer surface of the upper electrode; and
a first peripheral conductive line disposed on the interlayer insulating layer and disposed at the same vertical level as a vertical level of at least a portion of the first upper conductive pattern.

2. The semiconductor device of claim 1, further comprising:
a first peripheral pattern and a second peripheral pattern disposed on the first peripheral conductive line and spaced apart from each other; and
intermediate contact plugs respectively disposed between each pattern of the first and second peripheral patterns and the first peripheral conductive line,
wherein the first and second peripheral patterns are disposed at the same vertical level as a vertical level of at least a portion of the second upper conductive pattern.

3. The semiconductor device of claim 2,
wherein the second upper conductive pattern extends in the first direction, and
wherein the first and second peripheral patterns are spaced apart from each other in a first direction.

4. The semiconductor device of claim 2 or 3, wherein the second region is between the first region and an edge of the substrate and is adjacent to the edge of the substrate.

5. The semiconductor device of claim 2, 3 or 4, further comprising:
a second peripheral conductive line disposed on the second region of the substrate and disposed at the same vertical level as a vertical level of the second upper conductive pattern;
a peripheral contact plug penetrating the interlayer insulating layer, extending upwardly, and connected to the second peripheral conductive line; and
a peripheral circuit disposed at a vertical level lower than a vertical level of the interlayer insulating layer and electrically connected to the peripheral contact plug.

6. The semiconductor device of claim 5, further comprising:
a first etch stop layer disposed on the peripheral circuit; and
a second etch stop layer disposed on the first etch stop layer,
wherein the peripheral contact plug further includes:
a first peripheral contact plug having an external side surface covered by the second etch stop layer, penetrating the first etch stop layer, and electrically connected to the peripheral circuit; and
a second peripheral contact plug penetrating the interlayer insulating layer and the second etch stop layer and electrically connected to the first peripheral contact plug.

7. The semiconductor device of claim 5 or 6, wherein the first and second peripheral patterns are disposed between the second upper conductive pattern and the second peripheral conductive line.

8. The semiconductor device of claim 5, 6 or 7, further comprising:
a dummy structure disposed on one side of the second peripheral conductive line and configured to be in a floating state,
wherein the dummy structure includes:
a first dummy pattern in the second region and disposed at the same vertical level as a vertical level of the first peripheral conductive line;
a second dummy pattern disposed at the same vertical level as a vertical level of the second peripheral conductive line and overlapping the first dummy pattern in a vertical direction; and
a dummy contact plug connecting the first dummy pattern to the second dummy pattern,
wherein the second peripheral conductive line is disposed between the second dummy pattern and the second peripheral pattern.

9. The semiconductor device of any one of claims 5 to 8, further comprising:
a bit line disposed at a vertical level lower than a vertical level of the capacitor and the interlayer insulating layer;
a bit line contact structure electrically connected to the bit line extending to the second region; and
a bit line contact plug penetrating the interlayer insulating layer from the bit line contact structure disposed below the interlayer insulating layer, extending upwardly, and connected to the first peripheral pattern.

10. The semiconductor device of claim 9, wherein the second peripheral pattern and the second peripheral conductive line are integrated with each other.

11. The semiconductor device of any preceding claim, wherein an upper surface of the interlayer insulating layer is disposed at the same vertical level as a vertical level of the upper surface of the upper electrode.

12. The semiconductor device of any preceding claim, wherein the first upper conductive pattern and the first peripheral conductive line include a first interconnection material layer and a first barrier layer covering a side surface and a bottom surface of the first interconnection material layer.

13. The semiconductor device of any preceding claim,
wherein the first upper conductive pattern includes at least one of tungsten (W) and silicon-germanium (SiGe), and
wherein the second upper conductive pattern includes copper (Cu).

14. The semiconductor device of any one of claims 3 to 13, further comprising:
a second peripheral conductive line disposed at the same vertical level as a vertical level of the first and second peripheral patterns on the second region, disposed side by side with the first and second peripheral patterns in a second direction intersecting with the first direction, and extending in the first direction.

15. The semiconductor device of claim 14, wherein at least a portion of the second peripheral conductive line overlaps the first peripheral conductive line in a vertical direction.
